# EUROPEAN PATENT APPLICATION

(11) **EP 4 604 109 A1**
(43) Date of publication of application: **20.08.2025**
(21) Application number: 23956985.8
(22) Date of filing: 06.12.2023
(51) Int. Cl.: G09G 3/20

(54) **DISPLAY DRIVING ASSEMBLY, DISPLAY MODULE AND DISPLAY DEVICE**

(71) Applicant: Beijing Shiyan Technology Co., Ltd., Beijing 100176 (CN)
(72) Inventor: HAO, Kexin, Daxing District Beijing 100176 (CN); DUAN, Xin, Daxing District Beijing 100176 (CN); YU, Shuhuan, Daxing District Beijing 100176 (CN); CHU, Minglei, Daxing District Beijing 100176 (CN); LIU, Rui, Daxing District Beijing 100176 (CN); SUN, Wei, Daxing District Beijing 100176 (CN)
(74) Representative: AWA Sweden AB
(86) International application number: PCT/CN2023/136875
(87) International publication number: WO 2025/118195

(57) **Abstract**

A display driver assembly (300), a display module, and a display device are provided. The display driver assembly (300) includes a driver chip (310), which includes a first region (Q1) and a second region (Q2). The first region (Q1) includes a signal input interface (JK). The second region (Q2) includes: a first conductive layer (312) and a first insulating layer (313) on a first substrate (311); a plurality of output sub-regions (SC) on the first substrate (311), where the output sub-regions (SC) include a plurality of pin units (YJD), and the pin units (YJD) include a plurality of first pins (YJ1); a plurality of output units (SCD) on the first substrate (311), where the output unit (SCD) is electrically connected to the plurality of first pins (YJ1) through a multiplexing unit (MX); a first window unit (CKD1) in the first insulating layer (313), where the first window unit (CKD1) includes a plurality of windows, and the plurality of windows include a plurality of first windows (CK1) and a plurality of second windows (CK2). The plurality of pin units (YJD) include a first pin unit (YJD1) and a second pin unit (YJD2), the plurality of first windows (CK1) expose at least one of the first pins (YJ1) in the first pin unit (YJD1), and the plurality of second windows (CK2) expose at least one of the first pins (YJ1) in the second pin unit (YJD2). For any two of the plurality of first windows (CK1) and the plurality of second windows (CK2), the first pins (YJ1) exposed by the two windows are electrically connected to different output units (SCD).

## Description

### TECHNICAL FIELD

The present disclosure relates to a field of display technology, and in particular to a display driver assembly, a display module, and a display device.

### BACKGROUND

Currently, drive lines (such as data lines) on a display panel are controlled and driven by a display driver chip. The display driver chip may be provided on a printed circuit board, or on a flexible printed circuit board to form a chip-on-film (COF).

Compared with the solution of providing a display driver chip on a printed circuit board, the method of forming a chip-on-film structure allows the display driver chip to be placed on a side or back of a display panel, which helps achieve a narrow bezel.

### SUMMARY

In an aspect, a display driver assembly is provided, including a driver chip, where the driver chip includes a first region and a second region arranged along a first direction, the first region includes at least one signal input interface, and the second region includes: a first substrate; a first conductive layer on the first substrate; a first insulating layer on a side of the first conductive layer away from the first substrate; a plurality of output sub-regions on the first substrate, where the plurality of output sub-regions are arranged along a second direction, at least one output sub-region includes a plurality of pin units arranged along the first direction, and at least one pin unit includes a plurality of first pins; a plurality of output units on the first substrate, where at least one output unit is electrically connected to the plurality of first pins through a multiplexing unit, and different output units are electrically connected to different first pins; and a first window unit in the first insulating layer, where the first window unit includes a plurality of windows, the plurality of windows in the first window unit include a plurality of first windows and a plurality of second windows, and the plurality of second windows are located on a side of the plurality of first windows close to the first region; where the plurality of pin units include a first pin unit and a second pin unit, the second pin unit is located on a side of the first pin unit close to the first region, the plurality of first windows expose at least one of the first pins in the first pin unit, the plurality of second windows expose at least one of the first pins in the second pin unit, and first pins exposed by any two of the plurality of first windows and the plurality of second windows are electrically connected to different output units.

According to some exemplary embodiments, the display driver assembly further includes a flexible printed circuit board, and the flexible printed circuit board includes a second substrate; a first lead layer and a second lead layer on the second substrate, where the first lead layer is located on a side of the second substrate facing the driver chip, and the second lead layer is located on a side of the second substrate away from the driver chip; and a plurality of first leads, a plurality of second leads and a plurality of first connecting lines on the second substrate, where the plurality of first leads and the plurality of first connecting lines are located in the first lead layer, the plurality of second leads are located in the second lead layer, and an orthographic projection of the plurality of first connecting lines on the second substrate is located on a side of an orthographic projection of the plurality of first leads on the second substrate close to an orthographic projection of the first region on the second substrate; where the first pins exposed by the first windows are electrically connected to the plurality of first leads, and the first pins exposed by the second windows are electrically connected to the plurality of second leads through the plurality of first connecting lines.

According to some exemplary embodiments, the display driver assembly further includes a flexible printed circuit board, and the flexible printed circuit board includes: a second substrate; a first lead layer and a third lead layer on the second substrate, where the first lead layer is located on a side of the second substrate facing the driver chip, and the third lead layer is located between the first lead layer and the second substrate; and a plurality of first leads and a plurality of third leads on the second substrate, where the plurality of first leads are located in the first lead layer, the plurality of third leads are located in the third lead layer, and an orthographic projection of the plurality of first leads on the second substrate does not overlap with an orthographic projection of the plurality of second leads on the second substrate; where the first pins exposed by the first windows are electrically connected to the plurality of first leads, and the first pins exposed by the second windows are electrically connected to the plurality of third leads.

According to some exemplary embodiments, the flexible printed circuit board further includes: at least one fourth lead layer on the second substrate, where the at least one fourth lead layer is located between the third lead layer and the second substrate; and at least one set of fourth leads on the second substrate, where each set of fourth leads includes a plurality of fourth leads, the fourth leads in a same set of fourth leads are located in a same fourth lead layer, and the fourth leads in different set of fourth leads are located in different fourth lead layers; where the plurality of pin units further include at least one third pin unit on a side of the second pin unit away from the first pin unit; where the driver chip further includes at least one second window unit in the first insulating layer, the at least one second window unit includes a plurality of third windows and is located on a side of the first window unit close to the first region; where the third windows in the at least one second window unit expose the first pins in a same third pin unit, and the third windows in different second window units expose the first pins in different third pin units; and where the first pins exposed by the third windows in the at least one third pin unit are electrically connected to the fourth leads in the at least one set of fourth leads, and the first pins in different third pin units are electrically connected to the fourth leads in different sets of fourth leads.

According to some exemplary embodiments, an orthographic projection of the fourth leads in a (2n-1)^{th} fourth lead layer on the second substrate defines a first pattern, and an orthographic projection of the fourth leads in a 2n^{th} fourth lead layer on the second substrate defines a second pattern; an orthographic projection of the first pattern on the second substrate overlaps partially with the orthographic projection of the plurality of first leads on the second substrate, and an orthographic projection of the second pattern on the second substrate overlaps partially with the orthographic projection of the plurality of third leads on the second substrate; and where n is a positive integer.

According to some exemplary embodiments, the first window unit further includes a third window unit in the first insulating layer, and the third window unit includes a plurality of fourth windows and a plurality of fifth windows; and where the plurality of fourth windows expose the first pins not exposed by the first windows in the first pin unit, and the plurality of fifth windows expose the first pins not exposed by the second windows in the second pin unit.

According to some exemplary embodiments, at least one multiplexing unit includes a plurality of gating modules, at least one gating module is electrically connected to at least one first pin, and different gating modules are electrically connected to different first pins; and where first pins exposed by any two of the plurality of first windows and the plurality of second windows are electrically connected to gating modules having same port numbers.

According to some exemplary embodiments, the output units include a first output unit and a second output unit, and the plurality of gating modules of the at least one multiplexing unit include a first gating module; and where the first output unit is electrically connected to the first pin in the first pin unit through the first gating module of the multiplexing unit, and the second output unit is electrically connected to the first pin in the second pin unit through the first gating module of the multiplexing unit.

According to some exemplary embodiments, the at least one pin unit includes N sets of first pins, and in a same pin unit, at least one set of first pins includes a plurality of first pins arranged along the second direction, the N sets of first pins are arranged obliquely along a third direction, and the first direction, the second direction and the third direction intersect with each other; where at least one first pin includes a first side and a second side opposite to each other along the second direction, and in the at least one set of first pins YJZ, the first sides of two adjacent first pins define a first range on the first substrate, and an orthographic projection of at least M first pins on the first substrate overlaps with the first range; and where N and M are positive integers, and M≥3.

According to some exemplary embodiments, the first window unit includes a plurality of sets of first windows and a plurality of sets of second windows, at least one set of first windows includes a plurality of first windows arranged along a fourth direction, and at least one set of second windows includes a plurality of second windows arranged along the fourth direction; where the plurality of sets of first windows are arranged along the second direction, the plurality of sets of second windows are arranged along the second direction, and the first direction, the second direction, the third direction and the fourth direction intersect with each other; where in the at least one set of first windows, at least one first window exposes the first pin in the at least one set of first pins, and different first windows expose the first pins in different sets of first pins; and where in the at least one set of second windows, at least one second window exposes the first pin in the at least one set of first pins, and different second windows expose the first pins in different sets of first pins.

According to some exemplary embodiments, the driver chip further includes: a plurality of second pins on the first substrate; a first anti-static module and a first power compensation module on the first substrate; and an electrostatic discharge interface and a power compensation interface in the first region; where the first anti-static module is electrically connected to the electrostatic discharge interface through at least one of the plurality of second pins, and the first power compensation module is electrically connected to the power compensation interface through at least another one of the plurality of second pins; and where the second region includes a first compensation sub-region and a second compensation sub-region, the first compensation sub-region separates two adj acent output sub-regions, the second compensation sub-region is located on a side of the plurality of output sub-regions close to the first region, and the plurality of second pins are located in at least one of the first compensation sub-region or the second compensation sub-region.

According to some exemplary embodiments, the plurality of second pins include an anti-static compensation pin and a power compensation pin; where the first anti-static module is electrically connected to the anti-static compensation pin, and the first power compensation module is electrically connected to the power compensation pin; where the anti-static compensation pin and the power compensation pin are provided between any two adjacent output sub-regions; and/or where the anti-static compensation pin and the power compensation pin are provided on a side of each output sub-region close to the first region.

According to some exemplary embodiments, the display driver assembly further includes a flexible printed circuit board, and the flexible printed circuit board includes: a second substrate; a first lead layer on the second substrate, where the first lead layer is located on a side of the second substrate facing the driver chip; and a fifth lead, a sixth lead and a seventh lead disposed on the second substrate and located in the first lead layer; where the power compensation interface includes a first voltage terminal and a second voltage terminal, the power compensation pins include a first compensation pin and a second compensation pin, the anti-static compensation pin is electrically connected to the electrostatic discharge interface through the fifth lead, the first compensation pin is electrically connected to the first voltage terminal through the sixth lead, and the second compensation pin is electrically connected to the second voltage terminal through the seventh lead; where in the second compensation sub-region, the fourth lead, the fifth lead and the sixth lead extend along the second direction, and in the first compensation sub-region, the fourth lead, the fifth lead and the sixth lead are bent towards a side away from the first compensation sub-region; and where an orthographic projection of the fourth lead on the first substrate, an orthographic projection of the fifth lead on the first substrate, and an orthographic projection of the sixth lead on the first substrate do not overlap with each other.

According to some exemplary embodiments, the display driver assembly further includes a flexible printed circuit board, and the flexible printed circuit board includes: a second substrate; a first lead layer on the second substrate, where the first lead layer is located on a side of the second substrate facing the driver chip, and the third lead layer is located between the first lead layer and the second substrate; a fifth lead, a sixth lead, a seventh lead, an eighth lead, a ninth lead and a tenth lead disposed on the second substrate and located in the first lead layer, where the fourth lead, the fifth lead and the sixth lead are located in the first compensation sub-region and extend along the first direction, and the eighth lead, the ninth lead and the tenth lead are located in the second compensation sub-region and extend along the second direction; and a transition portion in the third lead layer, where the power compensation interface includes a first voltage terminal and a second voltage terminal, the power compensation pins include a first compensation pin and a second compensation pin, the anti-static compensation pin is electrically connected to the fifth lead, the first compensation pin is electrically connected to the sixth lead, and the second compensation pin is electrically connected to the seventh lead; where the fifth lead is electrically connected to the electrostatic discharge interface through the eighth lead, the sixth lead is electrically connected to the first voltage terminal through the ninth lead, and the seventh lead is electrically connected to the second voltage terminal through the tenth lead; and where at least two of the fifth lead, the sixth lead, the seventh lead, the eighth lead, the ninth lead and the tenth lead have overlapping orthographic projections on the first substrate, and in an overlapping region, one of the at least two is transitioned through the transition portion.

According to some exemplary embodiments, the driver chip further includes: a signal extension interface in the first region; and a signal extension pin on the first substrate, where the signal extension pin is located in the first compensation sub-region and on a side of the plurality of second pins away from the first region; where the flexible printed circuit board 320 further includes: a second connecting line and an eleventh lead on the second substrate, where the second connecting line is located in the first lead layer, and the eleventh lead is located in the second lead layer; and where the signal extension pin is electrically connected to the eleventh lead through the second connecting line, and the eleventh lead is electrically connected to the signal extension interface.

According to some exemplary embodiments, at least one first via hole is provided in the second substrate, a size of the first via hole is greater than or equal to a distance between two first pins adjacent in the second direction, the second connecting line and the eleventh lead are electrically connected to each other through the first via hole, and the first via hole is located on a side of the signal extension pin away from the first region; where a j^{th} first via hole is located on a side of a (j+1)^{th} first via hole away from the first region, and for the second connecting line and the eleventh lead electrically connected to each other through the (j+1)^{th} first via hole, the second connecting line surrounds at least partially the j^{th} first via hole, where j is a positive integer.

According to some exemplary embodiments, a projection of the second connecting line and the eleventh lead on the first substrate is located between orthographic projections of two adjacent output sub-regions on the first substrate.

According to some exemplary embodiments, the driver chip further includes a first power supply module and a control module; and where the first power supply module is electrically connected to a first power source, the first power supply module and the first power compensation module are electrically connected to at least one output sub-region through the control module, and the control module is configured to: in response to a gating instruction, connect or disconnect the output sub-region electrically connected to the control module to or from the first power supply module, and/or connect or disconnect the output sub-region electrically connected to the control module to or from the first power compensation module.

According to some exemplary embodiments, at least two first pins are arranged along the second direction, and at least two second pins are arranged along the second direction; and in the second direction, two adjacent first pins have a first distance, and two adjacent second pins have a second distance, and the second distance is greater than or equal to the first distance.

In another aspect, a display module is provided, the display module includes the display driver assembly as described above.

In another aspect, a display device is provided, the display device includes the display module as described above.

### BRIEF DESCRIPTION OF THE DRAWINGS

Through the following description of embodiments of the present disclosure with reference to the accompanying drawings, the above contents and other objectives, features and advantages of the present disclosure will become clearer. In the accompanying drawings:
FIG. 1 schematically shows a schematic diagram of a display module in a comparative example;
FIG. 2 schematically shows a schematic diagram of a display module in an embodiment of the present disclosure;
FIG. 3 schematically shows a plan view of a display panel according to an embodiment of the present disclosure;
FIG. 4 schematically shows a plan view of a display driver assembly according to an embodiment of the present disclosure;
FIG. 5 schematically shows a schematic diagram of a display driver assembly in a bent state according to an embodiment of the present disclosure;
FIG. 6 schematically shows a first plan view of a driver chip according to an embodiment of the present disclosure;
FIG. 7 schematically shows a second plan view of a driver chip according to an embodiment of the present disclosure;
FIG. 8A and FIG. 8B schematically show schematic diagrams of an electrical connection between an output unit, a multiplexing unit and a plurality of first pins according to an embodiment of the present disclosure;
FIG. 9 schematically shows a first schematic diagram of an electrical connection between first pins and output leads according to an embodiment of the present disclosure, in which only the first pins exposed by a first window CK1 and a second window CK2 are shown;
FIG. 10 schematically shows a schematic diagram of pin numbers of the first pins in FIG. 9;
FIG. 11 schematically shows a cross-sectional view taken along a section line BB' in FIG. 9;
FIG. 12 schematically shows a second schematic diagram of an electrical connection between first pins and output leads according to an embodiment of the present disclosure;
FIG. 13 schematically shows a cross-sectional view taken along a section line CC' in FIG. 12;
FIG. 14 schematically shows a schematic diagram of a second window unit in an embodiment of the present disclosure;
FIG. 15 schematically shows a third schematic diagram of an electrical connection between first pins and output leads according to an embodiment of the present disclosure;
FIG. 16 schematically shows a cross-sectional view taken along a section line DD' in FIG. 15;
FIG. 17 schematically shows a first schematic diagram of second pins according to an embodiment of the present disclosure;
FIG. 18 schematically shows a schematic diagram of a first anti-static module and a first power compensation module according to an embodiment of the present disclosure; and
FIG. 19 schematically shows a second schematic diagram of second pins according to an embodiment of the present disclosure.

### DETAILED DESCRIPTION OF EMBODIMENTS

In order to make objectives, technical solutions and advantages of embodiments of the present disclosure clearer, technical solutions of embodiments of the present disclosure will be clearly and completely described below with reference to the accompanying drawings. Clearly, the described embodiments are merely some embodiments rather than all embodiments of the present disclosure. Based on the described embodiments of the present disclosure, all additional embodiments obtained by those ordinary skilled in the art without carrying out inventive effort fall within the scope of protection of the present disclosure.

It should be noted that in the accompanying drawings, for the purpose of clarity and/or description, sizes and relative sizes of elements may be enlarged. Accordingly, the sizes and relative sizes of the elements need not to be limited to those shown in the figures. In the specification and the accompanying drawings, the same or similar reference numerals represent the same or similar components.

When an element is described as being "on", "connected to" or "coupled to" another element, the element may be directly on the another element, directly connected to the another element or directly coupled to the another element, or an intermediate element may be provided. However, when an element is described as being "directly on", "directly connected to" or "directly coupled to" another element, no intermediate element is provided. Other terms and/or expressions used to describe relationships between elements, such as "between" and "directly between", "adjacent to" and "directly adjacent to", "on" and "directly on", and so on, should be interpreted in a similar manner. Moreover, the term "connection" may refer to a physical connection, an electrical connection, a communicative connection, and/or a fluid connection. In addition, X-axis, Y-axis and Z-axis are not limited to three axes of a rectangular coordinate system, and may be interpreted in a broader meaning. For example, the X-axis, the Y-axis and the Z-axis may be perpendicular to each other, or may represent different directions that are not perpendicular to each other. For the purpose of the present disclosure, "at least one of X, Y or Z" and "at least one selected from a group consisting of X, Y and Z" may be interpreted as only X, only Y, only Z, or any combination of two or more of X, Y and Z, such as XYZ, XY, YZ and ZZ. As used herein, the term "and/or" includes any and all combinations of one or more of the listed related items.

It should be noted that although the terms "first", "second", and so on may be used herein to describe various components, members, elements, regions, layers and/or portions, these components, members, elements, regions, layers and/or portions should not be limited by these terms. Rather, these terms are used to distinguish one component, member, element, region, layer and/or portion from another one. Thus, for example, a first component, a first member, a first element, a first region, a first layer and/or a first portion discussed below may be referred to as a second component, a second member, a second element, a second region, a second layer and/or a second portion without departing from teachings of the present disclosure.

For ease of description, spatial relationship terms, such as "upper", "lower", "left", "right", etc. may be used herein to describe a relationship between an element or feature and another element or feature as shown in the figures. It should be understood that the spatial relationship terms are intended to cover other different orientations of a device in use or operation in addition to the orientation described in the figures. For example, if a device in the figures is turned upside down, an element or feature described as "below" or "under" another element or feature will be oriented "above" or "on" the another element or feature.

Herein, the terms "substantially", "about", "approximately", "roughly" and other similar terms are used as terms of approximation rather than terms of degree, and they are intended to explain an inherent deviation of a measured or calculated value that will be recognized by those ordinary skilled in the art. Taking into account a process fluctuation, a measurement problem, an error related to a measurement of a specific quantity (that is, a limitation of a measurement system) and other factors, the terms "about" or "approximately" used herein includes a stated value and means that a specific value determined by those ordinary skilled in the art is within an acceptable range of deviation. For example, "about" may mean being within one or more standard deviations, or within ±30%, ±20%, ±10% or ±5% of the stated value.

It should be noted that the expression "in the same layer" herein refers to a layer structure that is formed by firstly forming, using a same film forming process, a film layer used to form a specific pattern, and then patterning, using one-time patterning process, the film layer with a same mask. Depending on different specific patterns, the one-time patterning process may include a plurality of exposure, development or etching processes, and the specific pattern in the formed layer structure may be continuous or discontinuous. A plurality of elements, components, structures and/or portions "made of the same material in the same layer" are made of the same material and formed by the same patterning process. Generally, a plurality of elements, components, structures and/or portions "made of the same material in the same layer" have substantially the same thickness.

Those skilled in the art should understand that, unless otherwise specified, the expression "height" or "thickness" herein refers to a size in a direction perpendicular to a surface of each film layer provided on the display substrate, that is, a size in a light emitting direction of the display panel, or referred to as a size in a normal direction of the display device.

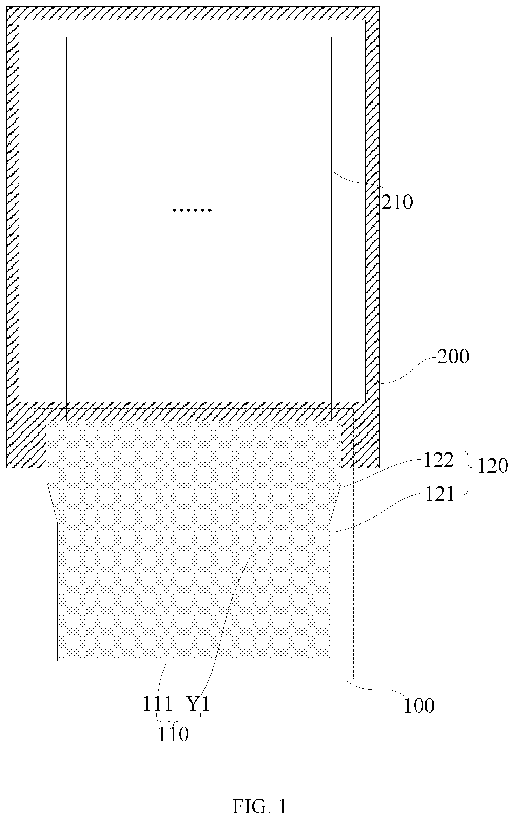

FIG. 1 schematically shows a schematic diagram of a display module in a comparative example.

Referring to FIG. 1, in a comparative example, the display module includes a display driver assembly 300 and a display panel 200. The display driver assembly 300 includes a driver chip 110 and a flexible printed circuit board 120. The driver chip 110 is disposed on the flexible printed circuit board 120 to form a chip-on-film (COF). For example, the flexible printed circuit board 120 includes a first substrate 121 and a plurality of first wire bundles 122 on the first substrate 121. Each first wire bundle 122 includes a plurality of output wires. The driver chip 110 is electrically connected to the display panel 200 through the plurality of first wire bundles 122 on the flexible printed circuit board 120.

The driver chip 110 includes a second substrate 111 and a plurality of output units on the second substrate 111. The output units may refer to internal circuits in the driver chip 110 used to output data voltage signals, which are not shown in the figures. The driver chip 110 further includes a plurality of first pins Y1 on the second substrate 111. The output units are arranged in a one-to-one correspondence with the first pins Y1. For example, each output unit is electrically connected to a first pin Y1. A plurality of drive lines 210 are provided on the display panel 200, and each first pin Y1 is electrically connected to a drive line 210 through the first wire bundle 122 to provide a corresponding driving signal to the drive line 210, thereby achieving a display function. In an example, the drive line L may include a data line, each first pin Y1 is electrically connected to a data line, and different first pins Y1 are electrically connected to different data lines, so as to provide corresponding data voltage signals to the data lines.

In the flexible printed circuit board 120, each output lead is electrically connected to a first pin Y1 in the driver chip 110 to form an output channel. Currently, display panels have various resolution requirements. A display panel with a conventional resolution generally requires no more than 4000 output channels, while a high-resolution display panel has high requirements for the number of output channels. For example, some high-resolution display panels currently require more than 10000 output channels.

To meet various requirements of display panels for output channels, the flexible printed circuit board 120 may be configured accordingly. For example, in an example, a flexible printed circuit board 120 with two lead layers is provided, in which output leads are distributed in the two lead layers, so that up to 4000 output leads may be arranged to meet the output channel requirements of a display panel with conventional resolution. In another example, a flexible printed circuit board 120 with three lead layers is provided, in which output leads are distributed in the three lead layers, so that more than 4000 output leads may be arranged to meet the output channel requirements of a high-resolution display panel.

Currently, the driver chip 110 is designed to match the flexible printed circuit board 120. For example, the first pins Y1 of the driver chip 110 are arranged in one-to-one correspondence with the output leads of the flexible printed circuit board 120. Specifically, the output leads include first ends for electrical connection with the first pins Y1, and an arrangement of the first pins Y1 is consistent with an arrangement of the first ends. Therefore, for different flexible printed circuit boards 120, it is necessary to redesign the arrangement of the first pins Y1 of the driver chip 110. Since the output units are also arranged in one-to-one correspondence with the first pins Y1, the internal circuit of the driver chip including the output units also needs to be modified accordingly when the arrangement of the first pins Y1 is changed, which results in a high design cost and a complex implementation.

In view of this, embodiments of the present disclosure provide a display driver assembly, including a driver chip. The driver chip includes a first region and a second region arranged along a first direction. The first region includes at least one signal input interface. The second region includes a first substrate, a first conductive layer on the first substrate, a first insulating layer on a side of the first conductive layer away from the first substrate, a plurality of output sub-regions on the first substrate, a plurality of output units on the first substrate, and a first window unit in the first insulating layer.

The plurality of output sub-regions are arranged along a second direction, at least one output sub-region includes a plurality of pin units arranged along the first direction, and at least one pin unit includes a plurality of first pins. At least one output unit is electrically connected to a plurality of first pins through a multiplexing unit, and different output units are electrically connected to different first pins. The first window unit includes a plurality of windows, which include a plurality of first windows and a plurality of second windows. The plurality of second windows are located on a side of the plurality of first windows close to the first region. The plurality of pin units include a first pin unit and a second pin unit, and the second pin unit is located on a side of the first pin unit close to the first region. The plurality of first windows expose at least one of the first pins in the first pin unit, and the plurality of second windows expose at least one of the first pins in the second pin unit. For any two windows in the first window unit, the first pins exposed by these two windows are electrically connected to different output units.

In embodiments of the present disclosure, an output unit is connected to a plurality of first pins through a multiplexing unit, so that the number of first pins may be multiplied without changing the internal circuit of the driver chip such as the output unit. On this basis, a basic part of the plurality of first pins may be exposed through the first windows and the second windows, so that the driver chip may adapt to at least a flexible printed circuit board with two lead layers. When facing a flexible printed circuit board with more lead layers, it is only needed to increase the number of windows and adjust the configuration of the multiplexing unit, without changing the internal circuit of the driver chip, so that the driver chip in embodiments of the present disclosure has high compatibility.

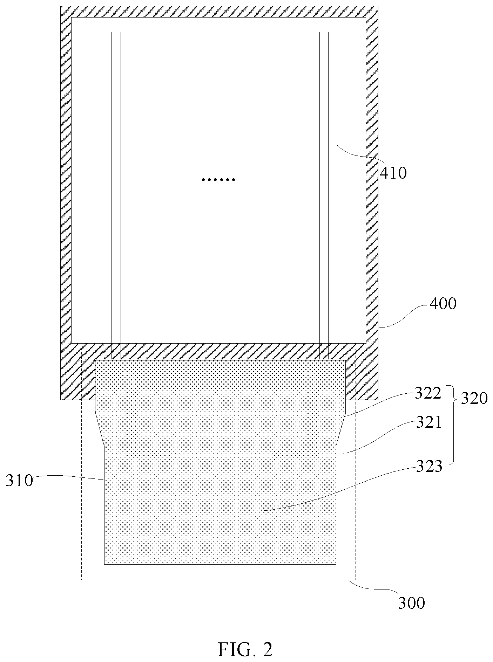

The display driver assembly in embodiments of the present disclosure will be described in detail below with reference to FIG. 2 to FIG.....

FIG. 2 schematically shows a schematic diagram of a display module in an embodiment of the present disclosure.

Referring to FIG. 2, the display module includes a display driver assembly 300 and a display panel 400. The display panel 400 includes a plurality of drive lines 410, and the display driver assembly 300 is used to provide at least driving signals to the drive lines 410. In an example, the drive lines 410 may include data lines, and correspondingly, the driving signals may include data voltage signals. However, embodiments of the present disclosure are not limited thereto. For example, the drive lines 410 may further include reference signal lines or the like

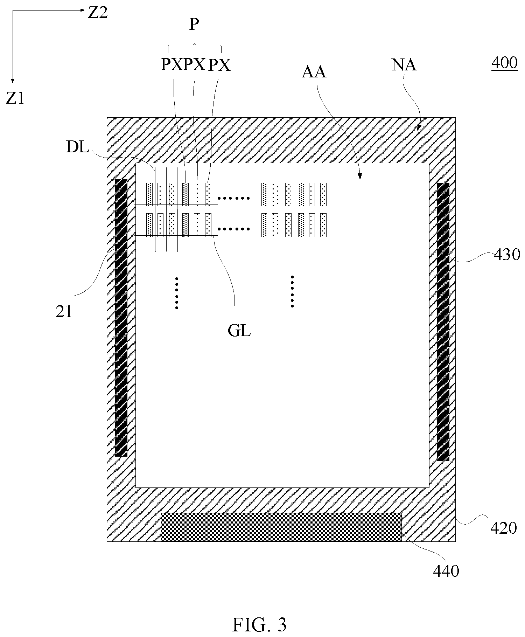

FIG. 3 schematically shows a plan view of a display panel according to an embodiment of the present disclosure.

Referring to FIG. 3, the display panel includes a display region AA and a peripheral region NA located on at least one side of the display region AA.

The display region AA may have various shapes. For example, the display region AA may be provided in various shapes such as a closed polygon including straight sides (e.g., a rectangle), a circle or an ellipse, etc. including a curved side, and a semicircle or a semi-ellipse, etc. including a straight side and a curved side. In embodiments of the present disclosure, the display region AA is provided as a region having a quadrangular shape including straight sides. It should be understood that this is merely an exemplary embodiment of the present disclosure, rather than a limitation to the present disclosure.

The display panel 400 may further include a base substrate 420 and a plurality of pixel units P on the base substrate 420, and the plurality of pixel units P are located in the display region AA. The plurality of pixel units P may be arranged in an array along a fifth direction Z1 and a sixth direction Z2, and the fifth direction Z1 intersects with the sixth direction Z2. For example, the fifth direction Z1 may include a vertical direction in FIG. 3, and the sixth direction Z2 may include a horizontal direction in FIG. 3, that is, the fifth direction Z1 and the sixth direction Z2 are perpendicular to each other.

Each pixel unit P may include a plurality of sub-pixels PX. For example, the pixel unit P may include a first sub-pixel, a second sub-pixel and a third sub-pixel. In an example, the first sub-pixel, the second sub-pixel and the third sub-pixel may be a red sub-pixel, a green sub-pixel and a blue sub-pixel, respectively.

The plurality of sub-pixels PX may be arranged in an array along the fifth direction Z1 and the sixth direction Z2, but embodiments of the present disclosure are not limited thereto. For the sake of description, in embodiments of the present disclosure, a plurality of sub-pixels PX arranged along the fifth direction Z1 are referred to as a column of sub-pixels PX, and a plurality of sub-pixels PX arranged along the sixth direction Z2 are referred to as a row of sub-pixels PX.

The display panel 400 further includes a plurality of gate lines GL and a plurality of data lines DL, which are provided on the base substrate 420 and located at least in the display region AA. The plurality of data lines DL extend along the fifth direction Z1, and the plurality of gate lines GL extend along the sixth direction Z2. In an example, a sub-pixel PX is correspondingly connected to a data line DL and a gate line GL, sub-pixels PX in the same row are connected to the same gate line GL, sub-pixels PX in different rows are connected to different gate lines GL, sub-pixels PX in the same column are connected to the same data line DL, and sub-pixels PX in different columns are connected to different data lines DL.

The peripheral region NA may be located on at least one side of the display region AA. For example, the peripheral region NA may surround a periphery of the display region AA. In embodiments of the present disclosure, the peripheral region NA may include a vertical portion extending in the fifth direction Z1 and a lateral portion extending in the sixth direction Z2.

The display panel 400 may further include a gate driver circuit 430 and a display bonding terminal 440, which are provided on the base substrate 420 and located in the peripheral region NA. For example, the gate driver circuit 430 may be located on at least one side of the display region AA. In embodiments shown in FIG. 3, the gate driver circuit 430 is located on a left side and a right side of the display region AA. It should be noted that the left side and the right side may refer to a left side and a right side of the display panel 400 (screen) as viewed by human eyes during display. For example, the display bonding terminal 440 may be located on at least one side of the display region AA. In embodiments shown in FIG. 3, the display bonding terminal 440 is located on a lower side of the display region AA. It should be noted that the lower side may be a lower side of the display panel 400 (screen) as viewed by human eyes during display. The display bonding terminal 440 is used for bonding to the display driver assembly 300.

It should be noted that FIG. 3 shows that the gate driver circuit 430 is located on the left side and the right side of the display region AA, and the display bonding terminal 440 is located on the lower side of the display region AA. However, embodiments of the present disclosure are not limited thereto. The gate driver circuit 430 and the display bonding terminal 440 may be located at any suitable positions in the peripheral region NA.

In embodiments of the present disclosure, a GOA technology, namely Gate Driver on Array, may be adopted for the gate driver circuit 430. In the GOA technology, the gate driver circuit 430 is provided directly on an array substrate to replace an external chip. Each GOA unit serves as a stage of shift register, and each stage of shift register is connected to a gate line GL. Scan signals are sequentially output through various stages of shift registers to achieve progressive scanning of pixel units. In some embodiments, each stage of shift register may also be connected to a plurality of gate lines GL. In this way, it may adapt to a development trend of high resolution and narrow bezel of the display panel 400.

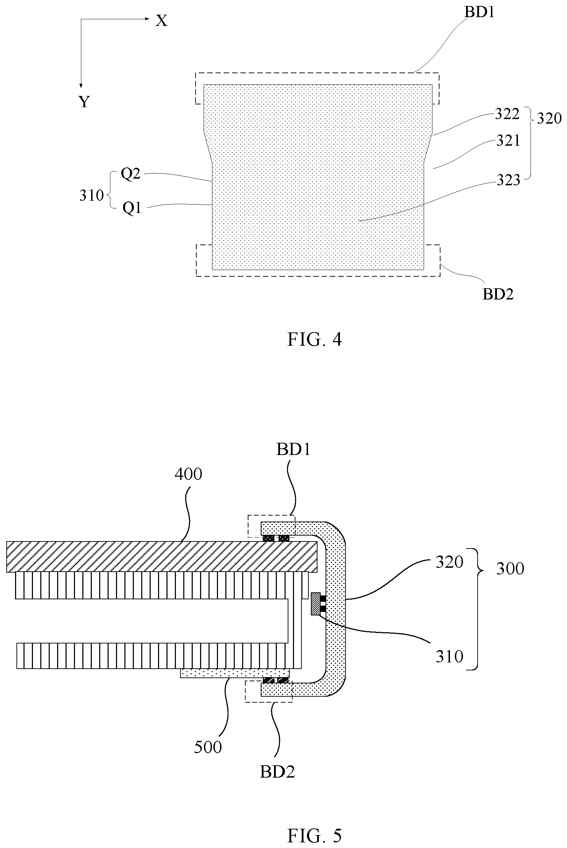

FIG. 4 schematically shows a plan view of a display driver assembly according to an embodiment of the present disclosure.

Referring to FIG. 2 and FIG. 4 in combination, the display driver assembly 300 in embodiments of the present disclosure includes a driver chip 310 and a flexible printed circuit board 320. The driver chip 310 is disposed on the flexible printed circuit board 320 to form a chip-on-film (COF). For example, the flexible printed circuit board 320 includes a first bonding terminal BD1 and a second bonding terminal BD2. The first bonding terminal BD1 is used for bonding to the display panel 400, and the second bonding terminal BD2 is used for bonding to a printed circuit board (PCB). The driver chip 310 is located between the first bonding terminal BD1 and the second bonding terminal BD2. The driver chip 310 is electrically connected to the first bonding terminal BD1 through an output lead 322 on the flexible printed circuit board 320, and thus electrically connected to the display panel 400. The output lead 322 may include at least one of a first lead, a second lead, a third lead, or a fourth lead mentioned below. The driver chip 310 is electrically connected to the second bonding terminal BD1 through an input lead 323 on the flexible printed circuit board 320, and thus electrically connected to the printed circuit board.

It should be noted that, for clarity of illustration, the display driver assembly 300 in FIG. 4 is shown in an unfolded state. In this state, the first bonding terminal BD1 may refer to an upper end of the flexible printed circuit board 320, and the second bonding terminal BD2 may refer to a lower end of the flexible printed circuit board 320.

FIG. 5 schematically shows a schematic diagram of a display driver assembly in a bent state according to an embodiment of the present disclosure.

Referring to FIG. 5, after the display driver assembly 300 is bonded to the display panel 400, the display driver assembly 300 is in a bent state, in which the first bonding terminal BD1 is bonded to the display bonding terminal 440 on the display panel 400, and the second bonding terminal BD2 is bent to a back side of the display panel 400 and then may be bonded to the printed circuit board 500 on the back side of the display panel 400.

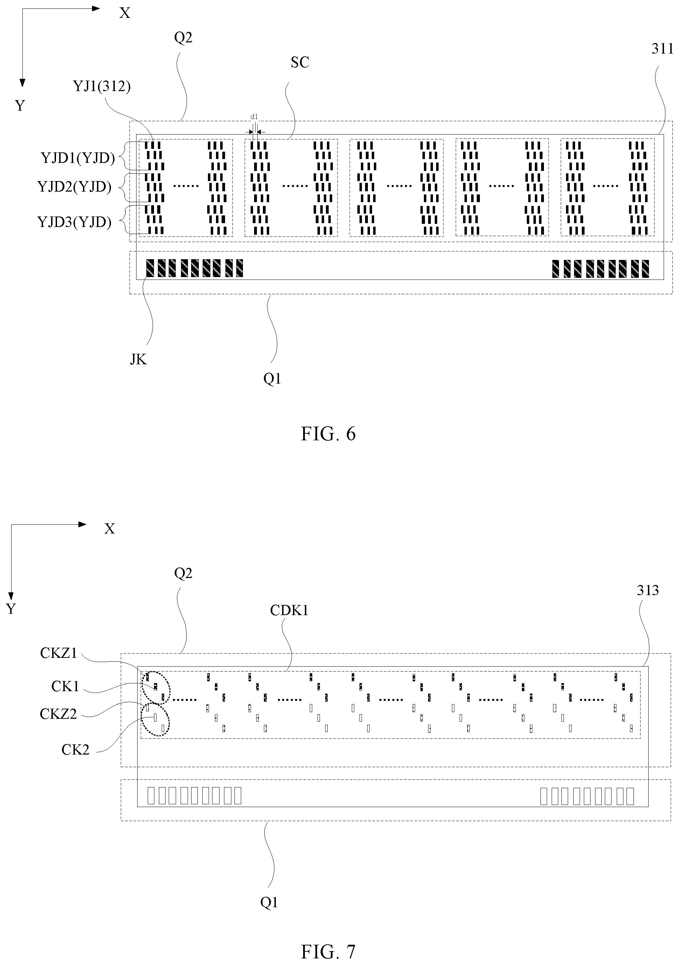

FIG. 6 schematically shows a first plan view of a driver chip according to an embodiment of the present disclosure, and FIG. 7 schematically shows a second plan view of a driver chip according to an embodiment of the present disclosure.

Referring to FIG. 6 and FIG. 7 in combination, the driver chip 310 includes a first region Q1 and a second region Q2 arranged along a first direction Y. For example, the first direction Y may be a vertical direction in FIG. 6. The first region Q1 includes at least one signal input interface JK. In an example, the first region Q1 includes a plurality of signal input interfaces JK, which may be arranged along a second direction X. For example, the second direction X may be a horizontal direction in FIG. 6. The signal input interface JK may be electrically connected to the second bonding terminal BD2 through the input lead 323 on the flexible printed circuit board 320, and thus electrically connected to the printed circuit board 500 through the second bonding terminal BD2.

The second region Q2 includes: a first substrate 311, a first conductive layer 312 on the first substrate 311, a first insulating layer 313 on a side of the first conductive layer 312 away from the first substrate 311, a plurality of output sub-regions SC on the first substrate 311, a plurality of output units on the first substrate 311, and a first window unit CKD1 in the first insulating layer 313. The output unit may refer to an internal circuit in the driver chip 310 used to output data voltage signals.

The plurality of output sub-regions SC are arranged along the second direction X, at least one output sub-region SC includes a plurality of pin units YJD arranged along the first direction Y, and at least one pin unit YJD includes a plurality of first pins YJ1.

In embodiments of the present disclosure, the plurality of output sub-regions SC are arranged along the horizontal direction in FIG. 6. Optionally, the plurality of output sub-regions SC are spaced apart from each other, and extension pins for power compensation, anti-static compensation, signal extension and other functions may be provided in a region between any two output sub-regions SC, which will be described in detail below and not be elaborated here.

In embodiments of the present disclosure, the plurality of first pins YJ1 are electrically connected to the first bonding terminal BD1 through the output leads 322 on the flexible printed circuit board 320. A plurality of first pins YJ1 in the same pin unit YJD are electrically connected to output leads 322 in the same film layer, and first pins YJ1 in different pin units YJD are electrically connected to output leads 322 in different film layers. For example, the first pins YJ1 in a first one of the pin units YJD are electrically connected to the first leads, and the first pins YJ1 in a second one of the pin units YJD are electrically connected to the second leads. The first leads and the second leads are arranged in different layers.

In embodiments shown in FIG. 6, a plurality of first pins YJ1 arranged along the second direction X are referred to as a row of first pins YJ1 (also referred to as a set of first pins hereinafter), and each three rows of first pins YJ1 form a pin unit YJD. Different pin units YJD include different first pins YJ1, that is, in any two pin units YJD, there are no identical first pins YJ1. The plurality of pin units YJD are arranged along the vertical direction in FIG. 6.

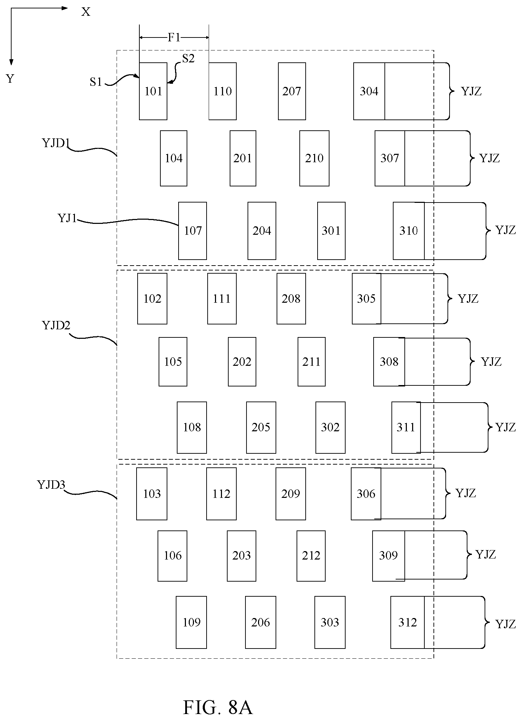

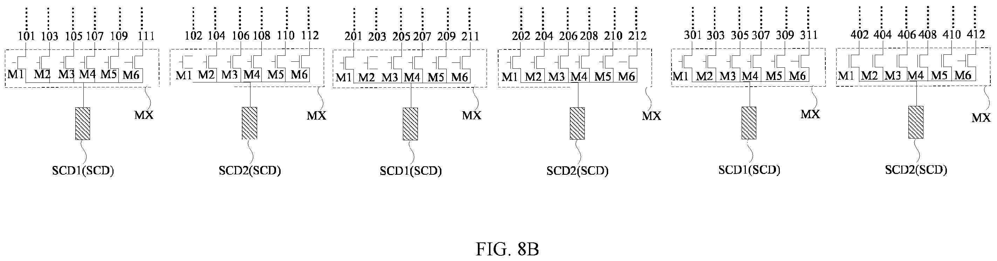

FIG. 8A and FIG. 8B schematically show schematic diagrams of an electrical connection between an output unit, a multiplexing unit and a plurality of first pins according to an embodiment of the present disclosure.

Referring to FIG. 6 to FIG. 8B in combination, at least one output unit SCD is electrically connected to a plurality of first pins YJ1 through a multiplexing unit MX, and different output units SCD are electrically connected to different first pins YJ1.

In embodiments of the present disclosure, the multiplexing unit MX may include a plurality of gating modules. For example, the plurality of gating modules include a first gating module M1, a second gating module M2, a third gating module M3, a fourth gating module M4, a fifth gating module M5, and a sixth gating module M6. Each gating module is electrically connected to a first pin YJ1, and different gating modules are electrically connected to different first pins YJ1. In an example, each first pin YJ1 has a pin number. Referring to FIG. 8A, the plurality of first pins YJ1 have pin numbers 101 to 312 respectively. For a first one of the output units SCD in FIG. 8B, the plurality of gating modules are electrically connected to the first pins YJ1 having pin numbers "101", "103", "105", "107", "109" and "111" respectively. For a second one of the output units SCD in FIG. 8B, the plurality of gating modules are electrically connected to the first pins YJ1 having pin numbers "102", "104", "106", "108", "110" and "112" respectively, and so on. The gating module is turned on in response to a gating instruction, so as to connect the output unit SCD to the corresponding first pin YJ1. The plurality of gating modules may be turned on in a predetermined timing sequence, and each output unit SCD may output corresponding driving signals in accordance with the timing sequence of turning on the gating modules. For example, the output unit SCD outputs a first driving signal when the first gating module M1 is turned on, the output unit SCD outputs a second driving signal when the second gating module M2 is turned on, and so on. In this way, it is possible to form a plurality of output channels by using one output unit SCD, and thus increase a total number of output channels of a single driver chip 310 without changing the number of output units SCD.

In embodiments of the present disclosure, it is possible to multiply the total number of first pins YJ1 of the driver chip 310 through the multiplexing unit MX without changing the number of output units SCD in the driver chip 310, and the total number of first pins YJ1 may be even multiplied to over 10000. Then, the actual number of exposed first pins YJ1 may be controlled by the number of windows. Therefore, the driver chip 310 in embodiments of the present disclosure may adapt to a flexible printed circuit board 320 with any number of lead layers.

Specifically, the first window unit CKD1 includes a plurality of windows, which include a plurality of first windows and a plurality of second windows. The plurality of second windows are located on a side of the plurality of first windows close to the first region Q1. The plurality of pin units YJD include a first pin unit YJD1 and a second pin unit YJD2, and the second pin unit YJD2 is located on a side of the first pin unit YJD1 close to the first region Q1. The plurality of first windows expose some first pins YJ1 in the first pin unit YJD1, and the plurality of second windows expose some first pins YJ1 in the second pin unit YJD2.

In embodiments of the present disclosure, the driver chip 310 may adapt to various flexible printed circuit boards 320 through the number and location of windows in the first insulating layer 313. For example, in an example, the flexible printed circuit board 320 may include two lead layers. In another example, the flexible printed circuit board 320 may include three lead layers. In still another example, the flexible printed circuit board 320 may include four or more lead layers, which will not be listed exhaustively in embodiments of the present disclosure.

In embodiments of the present disclosure, a plurality of pin units YJD may be provided, each pin unit YJD is electrically connected to leads in the same layer, and different pin units YJD are electrically connected to leads in different layers. The first insulating layer 313 is provided with at least a first window CK1 and a second window CK2, through which some of the first pins YJ1 in the first pin unit YJD1 and the second pin unit YJD2 in the driver chip 310 may be exposed. Accordingly, the driver chip 310 may adapt to at least a flexible printed circuit board 320 with two lead layers.

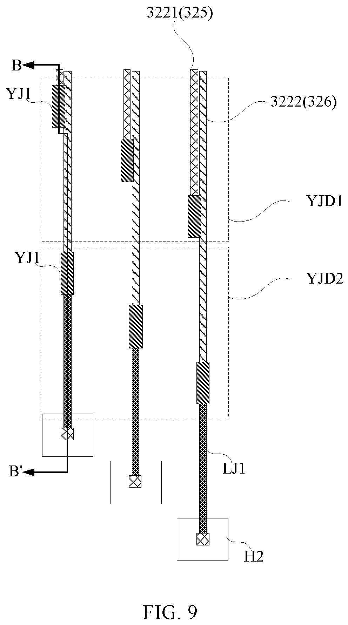

FIG. 9 schematically shows a first schematic diagram of an electrical connection between first pins and output leads according to an embodiment of the present disclosure, in which the first pins exposed by the first window CK1 and the second window CK2 are shown.

Referring to FIG. 9, the flexible printed circuit board 320 has two lead layers and a plurality of output leads 322. The plurality of output leads 322 include a first lead 3221 in one of the lead layers and a second lead 3222 in the other lead layer. The first pin YJ1 exposed by the first window CK1 may be electrically connected to the first lead 3221 on the flexible printed circuit board 320, and the first pin YJ1 exposed by the second window CK2 may be electrically connected to the second lead 3222 on the flexible printed circuit board 320 through a first connecting line LJ1. Referring to FIG. 7 and FIG. 9 in combination, the plurality of second windows CK2 are located below the plurality of first windows CK1, so that the exposed first pins YJ1 may be divided into two parts arranged along the first direction Y. Such pin arrangement is consistent with the arrangement of the first leads 3221 and the second leads 3222 described above. Thus, the flexible printed circuit board 320 may be directly pressed onto the driver chip 310 to complete the bonding of the flexible printed circuit board 320 and the driver chip 310. That is, the driver chip 310 in embodiments of the present disclosure may adapt to a flexible printed circuit board 320 with two lead layers.

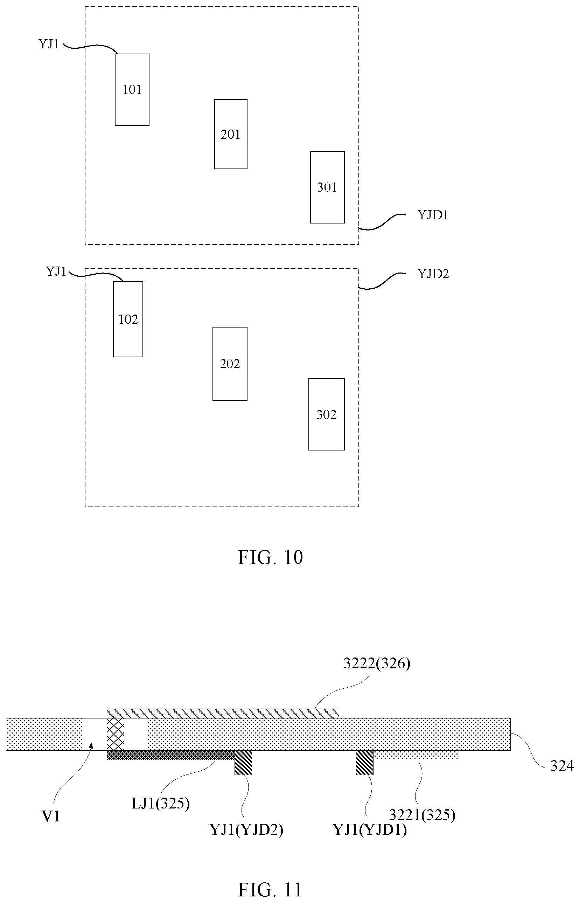

FIG. 10 schematically shows a schematic diagram of pin numbers of the first pins in FIG. 9.

Referring to FIG. 8A, FIG. 8B and FIG. 10 in combination, in embodiments of the present disclosure, for any two windows in the first window unit CKD1, the first pins YJ1 exposed by the two windows are electrically connected to different output units SCD.

For a flexible printed circuit board 320 with two lead layers, through the above method, each output lead 322 of the flexible printed circuit board 320 may be correspondingly connected to an output unit SCD. In this case, only one gating module (such as the first gating module M1) in the multiplexing unit MX needs to operate to achieve adaptation to this type of flexible printed circuit board 320.

For a flexible printed circuit board 320 with a plurality of lead layers, when the number of output leads 322 is greater than the number of output units SCD of the driver chip 310, it is possible to provide more windows in the first insulating layer 313 to expose more first pins YJ1. Since an output unit SCD is connected to a plurality of first pins YJ1 through a multiplexing unit MX, it is only needed to adjust the configuration of the multiplexing unit MX and activate a specified number of gating modules in the multiplexing unit MX to achieve adaptation to this type of flexible printed circuit board 320.

Generally, in embodiments of the present disclosure, an output unit SCD is connected to a plurality of first pins YJ1 through a multiplexing unit MX, so that the number of first pins YJ1 may be multiplied without changing the internal circuit of the driver chip such as the output unit SCD. On this basis, a basic portion of the plurality of first pins YJ1 may be exposed through the first windows CK1 and the second windows CK2, so that the driver chip 320 may adapt to at least a flexible printed circuit board 310 with two lead layers. When facing a flexible printed circuit board 320 with more lead layers, it is only needed to increase the number of windows and adjust the configuration of the multiplexing unit MX, without changing the internal circuit of the driver chip, so that the driver chip 320 in embodiments of the present disclosure has high compatibility.

The display driver assembly 300 in embodiments of the present disclosure will be further described below with reference to FIG. 2 to FIG. 19.

FIG. 11 schematically shows a cross-sectional view taken along a section line BB' in FIG. 9.

Referring to FIG. 11, in some specific embodiments, the display driver assembly 300 further includes a flexible printed circuit board 320. The flexible printed circuit board 320 includes: a second substrate 324; a first lead layer 325 and a second lead layer 326 on the second substrate 324; and a plurality of first leads 3221, a plurality of second leads 3222 and a plurality of first connecting lines LJ1 on the second substrate 324.

The first lead layer 325 is located on a side of the second substrate 324 facing the driver chip 310, and the second lead layer 326 is located on a side of the second substrate 324 away from the driver chip 310. The plurality of first leads 3221 and the plurality of first connecting lines LJ1 are located in the first lead layer 325, and the plurality of second leads 3222 are located in the second lead layer 326. An orthographic projection of the plurality of first connecting lines LJ1 on the second substrate 324 is located on a side of an orthographic projection of the plurality of first leads 3221 on the second substrate 324 close to an orthographic projection of the first region Q1 on the second substrate 324.

In embodiments of the present disclosure, the flexible printed circuit board 320 includes two lead layers (the first lead layer 325 and the second lead layer 326), which are located on opposite sides of the second substrate 324. Referring to FIG. 11, the first lead layer 325 is closer to the driver chip 310 than the second substrate 324, and the second substrate 324 is closer to the driver chip 310 than the second lead layer 326.

The second substrate 324 is provided with a first via hole V1 penetrating through the second substrate 324. Each first connecting line LJ1 is electrically connected to a second lead 3222 through a first via hole V1, and different first connecting lines LJ1 are electrically connected to different second leads 3222. Since the first via hole V1 needs to penetrate through the second substrate 324, an opening size of the first via hole V1 is large and much greater than a distance d1 between two first pins YJ1 adjacent in the second direction X. Therefore, the first via hole V1 is positioned on a side away from the first pins YJ1. For example, in embodiments of the present disclosure, the first via hole V1 is positioned on a side of the first pins YJ1 close to the first region Q1 to avoid the first pins YJ1 and the output leads 322, thereby preventing short-circuiting of different first pins YJ1 due to an overlap of the first via hole V1 with the first pins YJ1.

The first pins YJ1 exposed by the first windows CK1 are electrically connected to the plurality of first leads 3221, and the first pins YJ1 exposed by the second windows CK2 are electrically connected to the plurality of second leads 3222 through the plurality of first connecting lines LJ1.

In embodiments of the present disclosure, for the first pins YJ1 exposed by the first windows CK1, each first pin YJ1 is electrically connected to a first lead 3221, and different first pins YJ1 are electrically connected to different first leads 3221. For the first pins YJ1 exposed by the second windows CK2, each first pin YJ1 is electrically connected to a first connecting line LJ1, and different first pins YJ1 are electrically connected to different first connecting lines LJ1. As described above, the first pins YJ1 exposed by the first windows CK1 are located on the side of the first pins YJ1 exposed by the second windows CK2 away from the first region Q1. Therefore, the first lead 3221 may extend, from a position of the first pin YJ1, directly towards a side away from the first region Q1 until it is electrically connected to the first bonding terminal BD1. Since the first via hole V1 is positioned on the side of the first pin YJ1 close to the first region Q1, the first connecting line LJ1 may extend, from the position of the first pin YJ1, towards the side close to the first region Q1 until it reaches the first via hole V1, and then may be electrically connected to the second lead 3222 at the first via hole V1. After that, the second lead 3222 extends towards the side away from the first region Q1 until it is electrically connected to the first bonding terminal BD1.

Optionally, an orthographic projection of the first lead 3221 on the first substrate 311 is spaced apart from an orthographic projection of the second lead 3222 on the first substrate 311, so that a parasitic capacitance between the first lead 3221 and the second lead 3222 may be reduced or even avoided. For example, in the second direction X, the first leads 3221 and the second leads 3222 are arranged alternately. In an example, the orthographic projection of the first lead 3221 on the first substrate 311 is located between orthographic projections of two adjacent second leads 3222 on the first substrate 311, or the orthographic projection of the second lead 3222 on the first substrate 311 is located between orthographic projections of two adjacent first leads 3221 on the first substrate 311. It should be noted that, in embodiments of the present disclosure, the expression "two adjacent second leads 3222" or a similar expression means that there is no other second lead 3222 between these two second leads 3222.

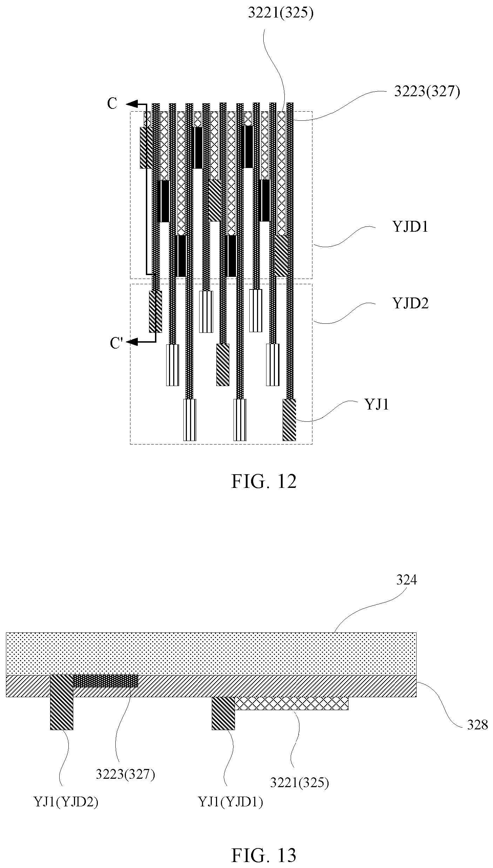

FIG. 12 schematically shows a second schematic diagram of an electrical connection between first pins and output leads according to an embodiment of the present disclosure. FIG. 13 schematically shows a cross-sectional view taken along a section line CC' in FIG. 12. In FIG. 12, in addition to the first pins YJ1 exposed by the first window CK1 and the second window CK2, the first pins YJ1 exposed by a fourth window CK4 and a fifth window CK5 are further shown. The fourth window CK4 and the fifth window CK5 will be described in detail below and not be elaborated here.

Referring to FIG. 12 and FIG. 13 in combination, in some specific embodiments, the display driver assembly 300 further includes a flexible printed circuit board 320. The flexible printed circuit board 320 includes: a second substrate 324, a first lead layer 325 and a third lead layer 327 on the second substrate 324, and a plurality of first leads 3221 and a plurality of third leads 3223 on the second substrate 324.

The first lead layer 325 is located on a side of the second substrate 324 facing the driver chip 310, and the third lead layer 327 is located between the first lead layer 325 and the second substrate 324. The plurality of first leads 3221 are located in the first lead layer 325, and the plurality of third leads 3223 are located in the third lead layer 327.

In embodiments of the present disclosure, the flexible printed circuit board 320 also includes two lead layers (the first lead layer 325 and the third lead layer 327). Unlike the aforementioned embodiments, these two lead layers are located on the same side of the second substrate 324. Referring to FIG. 13, the second lead layer 326 is closer to the driver chip 310 than the second substrate 324, and the first lead layer 325 is closer to the driver chip 310 than the second lead layer 326.

A second insulating layer 328 is provided between the first lead layer 325 and the third lead layer 327, and the second insulating layer 328 insulates and separates the first lead layer 325 and the third lead layer 327. The second insulating layer 328 is provided with a second via hole penetrating through the second insulating layer 328. Each second lead 3222 is electrically connected to a first pin YJ1 through a second via hole, and different second leads 3222 are electrically connected to different first pins YJ1. Since the second via hole does not need to penetrate through the second substrate 324, an opening size of the second via hole is small and may be smaller than a distance d1 between two adjacent first pins YJ1. Therefore, an orthographic projection of the second via hole on the first substrate 311 may overlap with an orthographic projection of the first pin YJ1 on the first substrate 311.

The first pins YJ1 exposed by the first windows CK1 are electrically connected to the plurality of first leads 3221, and the first pins YJ1 exposed by the second windows CK2 are electrically connected to the plurality of third leads 3223.

In embodiments of the present disclosure, for the first pins YJ1 exposed by the first windows CK1, each first pin YJ1 is electrically connected to a first lead 3221, and different first pins YJ1 are electrically connected to different first leads 3221. For the first pins YJ1 exposed by the second windows CK2, each first pin YJ1 is electrically connected to a second lead 3222, and different first pins YJ1 are electrically connected to different second leads 3222. Both the first lead 3221 and the third lead 3223 extend, from the first pins YJ1 electrically connected thereto, towards the side away from the first region Q1 until they are electrically connected to the first bonding terminal BD1. Compared with the second lead 3222 in the aforementioned embodiments, the third lead 3223 in this embodiment has a shorter routing distance and a lower loss.

Referring to FIG. 12, the orthographic projections of the plurality of first leads 3221 on the second substrate 324 do not overlap with the orthographic projections of the plurality of second leads 3222 on the second substrate 324, so that a parasitic capacitance between the first leads 3221 and the third leads 3223 may be reduced or even avoided. For example, in the second direction X, the first leads 3221 and the third leads 3223 are arranged alternately. In an example, the orthographic projection of the first lead 3221 on the first substrate 311 is located between orthographic projections of two adjacent third leads 3223 on the first substrate 311, or the orthographic projection of the third lead 3223 on the first substrate 311 is located between orthographic projections of two adjacent first leads 3221 on the first substrate 311.

It should be noted that, in this embodiment of the present disclosure, it is also possible to provide a second lead layer 326, a first connecting line LJ1 and a first via hole V1. However, unlike the aforementioned embodiments, in this embodiment of the present disclosure, the first pin YJ1 electrically connected to the first connecting line LJ1 may be the first pin YJ1 in the pin unit YJD closest to the first region Q1. The first pins YJ1 in the other pin units YJD extend directly towards the first bonding terminal BD1 through the first leads 3221 and the third leads 3223 and are electrically connected to the first bonding terminal BD1, while the first pins YJ1 in the pin unit YJD closest to the first region Q1 first extend towards the first region Q1 through the first connecting lines LJ1, and then are electrically connected to the second leads 3222 through the first via holes V1, and then extend towards the first bonding terminal BD1 through the second leads 3222 until they are electrically connected to the first bonding terminal BD1.

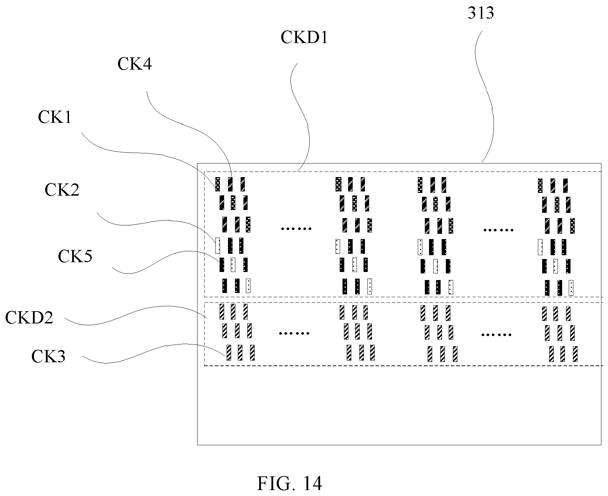

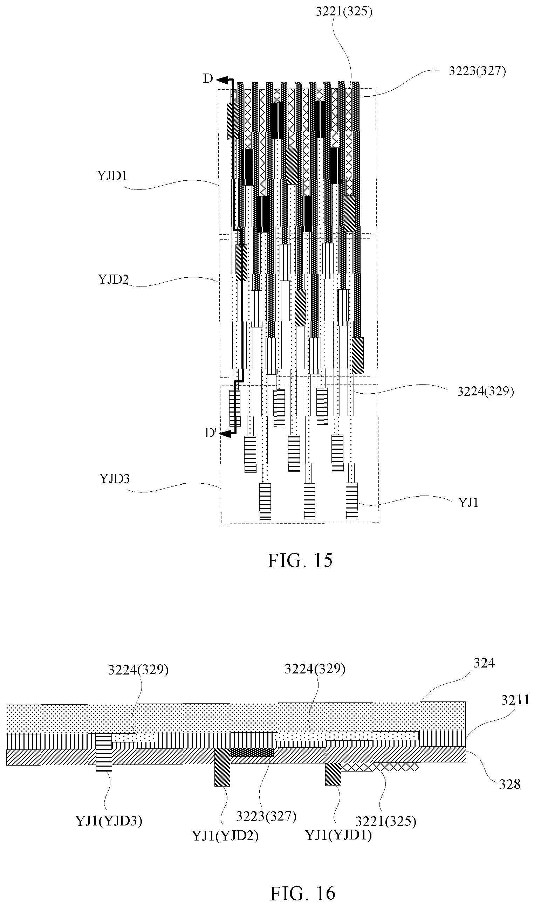

FIG. 14 schematically shows a schematic diagram of a second window unit in an embodiment of the present disclosure. FIG. 15 schematically shows a third schematic diagram of an electrical connection between first pins and output leads according to an embodiment of the present disclosure. FIG. 16 schematically shows a cross-sectional view taken along a section line DD' in FIG. 15. In FIG. 15, in addition to the first pins YJ1 exposed by the first windows CK1, the second windows CK2, the fourth windows CK4 and the fifth windows CK5, the first pins YJ1 exposed by the third windows CK3 are also shown.

Referring to FIG. 14 to FIG. 16 in combination, in some specific embodiments, the flexible printed circuit board 320 further includes: at least one fourth lead layer 329 on the second substrate 324, at least one set of fourth leads on the second substrate 324, and at least one second window unit CKD2 in the first insulating layer 313.

The fourth lead layer 329 is located between the third lead layer 327 and the second substrate 324. At least one set of fourth leads includes a plurality of fourth leads 3224, fourth leads 3224 in the same set of fourth leads are located in the same fourth lead layer 329, and fourth leads 3224 in different set of fourth leads are located in different fourth lead layers 329.

It should be noted that, in embodiments of the present disclosure, the first lead 3221, the second lead 3222, the third lead 3223 and the fourth lead 3224 may be collectively referred to as output leads 322. Each output lead 322 is connected to a first pin YJ1 to form an output channel, and different output leads 322 are connected to different first pins YJ1.

In embodiments of the present disclosure, the flexible printed circuit board 320 may be provided with one or more fourth lead layers 329. The more fourth lead layers 329 are provided, the more output leads 322 may be provided on the flexible printed circuit board 320. The plurality of fourth lead layers 329 are arranged in sequence along a direction approaching the second substrate 324, and each fourth lead layer 329 may be provided with a plurality of fourth leads 3224. A third insulating layer 3210 is provided between two adjacent fourth lead layers 329, and the third insulating layer 3210 is used to insulate and separate the fourth leads 3224 in two adjacent fourth lead layers 329.

The plurality of pin units YJD further include at least one third pin unit YJD3, which is located on a side of the second pin unit YJD2 away from the first pin unit YJD1.

In embodiments of the present disclosure, one or more third pin units YJD3 may be provided on the driver chip 310, and a plurality of third pin units YJD3 are arranged in sequence along a direction progressively approaching the first region Q1. The more third pin units YJD3 are provided, the more first pins YJ1 are provided on the driver chip 310.

At least one second window unit CKD2 includes a plurality of third windows CK3, and the second window unit CKD2 is located on a side of the first window unit CKD1 close to the first region Q1. Third windows CK3 in at least one second window unit CKD2 expose first pins YJ1 in the same third pin unit YJD3, and third windows CK3 in different second window units CKD2 expose first pins YJ1 in different third pin units YJD3. The first pins YJ1 exposed by the third windows CK3 in at least one third pin unit YJD3 are electrically connected to the fourth leads 3224 in at least one set of fourth leads, and the first pins YJ1 in different third pin units YJD3 are electrically connected to the fourth leads 3224 in different set of fourth leads.

In embodiments of the present disclosure, the driver chip 310 may be provided with one or more second window units CKD2. A plurality of second window units CKD2 are arranged in sequence along a direction progressively approaching the first region Q1. The more second window units CKD2 are provided, the more first pins YJ1 are exposed on the driver chip 310.

In embodiments of the present disclosure, the second window units CKD2 are arranged in one-to-one correspondence with the fourth lead layers 329. For example, for each additional fourth lead layer 329 on the flexible printed circuit board 320, a corresponding second window unit CKD2 may be added on the driver chip 310. For the third pin units YJD3 exposed by the second window units CKD2, the third pin units YJD3 are also arranged in one-to-one correspondence with the fourth lead layers 329. For example, for each third pin unit YJD3, the first pins YJ1 in that third pin unit YJD3 are only electrically connected to the fourth leads 3224 in the corresponding fourth lead layer 329.

In embodiments of the present disclosure, the first windows CK1 and the second windows CK2 may also be referred to as basic output windows, and the first pins YJ1 exposed by the first windows CK1 and the second windows CK2 may also be referred to as basic output pins. Through these basic output pins, the driver chip 310 may adapt to at least a flexible printed circuit board 320 with two lead layers. Correspondingly, the third windows CK3 may also be referred to as extension output windows. Through the third windows CK3, more first pins YJ1 may be exposed on the basis of the first windows CK1 and the second windows CK2, so that the driver chip 310 may adapt to a flexible printed circuit board 320 with more than two lead layers and more output channels are provided.

Optionally, a plurality of third windows CK3 in the same second window unit CKD2 may expose some of the first pins YJ1 in a third pin unit YJD3. Taking one second window unit CKD2 as an example, when only the first windows CK1 and the second windows CK2 are provided on the first pin unit YJD1 and the second pin unit YJD2 of the driver chip 310, the plurality of third windows CK3 may expose some of the first pins YJ1 in one third pin unit YJD3. In this case, the first windows CK1, the second windows CK2 and the third windows CK3 may be arranged in the same manner, so that the first pins YJ1 exposed by these windows are arranged in consistent manner, which is beneficial to bonding with the flexible printed circuit board 320.

It should be noted that a plurality of second window units CKD2 may be consistent in terms of the arrangement of third windows CK3, which will not be described in detail in embodiments of the present disclosure.

Referring to FIG. 15, in some specific embodiments, an orthographic projection of the fourth leads 3224 in a (2n-1)^{th} fourth lead layer 329 on the second substrate 324 defines a first pattern, and an orthographic projection of the fourth leads 3224 in a 2n^{th} fourth lead layer 329 on the second substrate 324 defines a second pattern. An orthographic projection of the first pattern on the second substrate 324 overlaps partially with the orthographic projection of the plurality of first leads 3221 on the second substrate 324, and an orthographic projection of the second pattern on the second substrate 324 overlaps partially with the orthographic projection of the plurality of third leads 3223 on the second substrate 324. n is a positive integer.

In embodiments of the present disclosure, the first pattern (or the second pattern) may refer to a pattern enclosed by boundaries of the orthographic projection of the fourth leads 3224 on the second substrate 324. Through the above-mentioned method, a total area occupied by the output leads 322 may be reduced. Furthermore, any two overlapping output leads 322 are spaced apart by a lead layer between them. In this way, on the one hand, a large distance may be formed between the two output leads 322 to reduce a parasitic capacitance between the two, and on the other hand, the lead layer between the two output leads 322 may have a shielding function to further reduce the parasitic capacitance between the two output leads 322. For example, if the first lead 3221 and the fourth lead 3224 in a first one of the fourth lead layers 329 overlap with each other, they may be spaced apart by the third lead layer 327, and if the third lead 3223 and the fourth lead 3224 in a second one of the fourth lead layers 329 overlap with each other, they may be spaced apart by the first one of the fourth lead layers 329, and so on.

Referring to FIG. 12 and FIG. 15 in combination, in some specific embodiments, the first window unit CKD1 further includes a plurality of fourth windows CK4 and a plurality of fifth windows CK5. The plurality of fourth windows CK4 expose the first pins YJ1 not exposed by the first windows CK1 in the first pin unit YJD 1, and the plurality of fifth windows CK5 expose the first pins YJ1 not exposed by the second windows CK2 in the second pin unit YJD2.

In embodiments of the present disclosure, the plurality of first windows CK1 expose some of the first pins YJ1 in the first pin unit YJD1, and the plurality of fourth windows CK4 expose the remaining first pins YJ1 in the first pin unit YJD1, so that all the first pins YJ1 in the first pin unit YJD1 may be exposed. The plurality of second windows CK2 expose some of the first pins YJ1 in the second pin unit YJD2, and the plurality of fifth windows CK5 expose the remaining first pins YJ1 in the second pin unit YJD2, so that all the first pins YJ1 in the second pin unit YJD2 may be exposed.

Optionally, a plurality of third windows CK3 in the same second window unit CKD2 may expose all the first pins YJ1 in a third pin unit YJD3. Taking one second window unit CKD2 as an example, when the driver chip 310 is provided with the fourth windows CK4 and the fifth windows CK5, the plurality of third windows CK3 may expose all the first pins YJ1 in a third pin unit YJD3.

In embodiments of the present disclosure, the first windows CK1, the second windows CK2, the third windows CK3, the fourth windows CK4 and the fifth windows CK5 may be collectively referred to as output windows. Each output window exposes a first pin YJ1, and different output windows expose different first pins YJ1, all the first pins YJ1 may be exposed to maximize the number of output channels.

Referring to FIG. 8A and FIG. 8B, in some specific embodiments, at least one multiplexing unit MX includes a plurality of gating modules. At least one gating module is electrically connected to at least one first pin YJ1, and different gating modules are electrically connected to different first pins YJ1. For any two windows among the plurality of first windows CK1 and the plurality of second windows CK2, the first pins YJ1 exposed by the two windows are electrically connected to gating modules having same port numbers.

In embodiments of the present disclosure, each output unit SCD is connected to a plurality of first pins YJ1 through a multiplexing unit MX, and different output units SCD are connected to different first pins YJ1. Each multiplexing unit MX includes a plurality of gating modules. Each gating module may be turned on or turned off in response to a gating signal. When a gating module is turned on, the first pin YJ1 electrically connected to the gating module may be connected to the output unit SCD, so that an electrical signal of the output unit SCD may be transmitted to the first pin YJ1 and then transmitted to the first bonding terminal BD1 of the flexible printed circuit board 320 through the corresponding output lead 322.

In embodiments of the present disclosure, for a multiplexing unit MX, the gating modules may be turned on in sequence, and only one gating module is turned on at any moment. Accordingly, the output unit SCD may configure output signals according to a turn-on order of the gating modules, so that a corresponding output signal may be output when each gating module is turned on.

In an example, when 2000 output units SCD are provided in the driver chip 310 and each output unit SCD is connected to a multiplexing unit MX, if each multiplexing unit MX includes six gating modules, it is possible to achieve 12000 output signals, and 12000 output channels may be achieved through a sufficient number of first pins YJ1 and output leads 322 on the flexible printed circuit board 320, which may meet the requirements of a high-resolution display panel 400 for the number of output channels.

In some specific embodiments, the output unit SCD includes a first output unit SCD1 and a second output unit SCD2, and the plurality of gating modules of at least one multiplexing unit MX include a first gating module. The first output unit SCD1 is electrically connected to the first pin YJ1 in the first pin unit YJD1 through the first gating module of the multiplexing unit MX, and the second output unit SCD2 is electrically connected to the first pin YJ1 in the second pin unit YJD2 through the first gating module of the multiplexing unit MX.

In other words, for any output unit SCD, a first pin YJ1 electrically connected to the first gating module is located in either the first pin unit YJD1 or the second pin unit YJD2. In this way, the first pins YJ1 electrically connected to the first gating module may be grouped into the first pin unit YJD1 and the second pin unit YJD2. In this case, the first pins YJ1 in the first pin unit YJD1 and the second pin unit YJD2 that are electrically connected to the first gating module may be exposed respectively through the first window CK1 and the second window CK2, and the multiplexing unit MX may be controlled to only turn on the first gating module, so that the driver chip 310 may adapt to a flexible printed circuit board 320 with two lead layers.

Referring to FIG. 8A, in some specific embodiments, at least one pin unit YJD includes N sets of first pins YJZ. In a pin unit YJD, at least one set of first pins YJZ includes a plurality of first pins YJ1 arranged along the second direction X, and at least one first pin YJ1 includes a first side S1 and a second side S2 opposite to each other along the second direction X. In at least one set of first pins YJZ, an orthographic projection of the first sides S1 of two adjacent first pins YJ1 on the first substrate 311 defines a first range F1, and orthographic projections of at least M first pins YJ1 on the first substrate 311 overlap with the first range F1, where M≥2.

Referring to FIG. 8A, in embodiments of the present disclosure, a plurality of first pins YJ1 in any set of first pins YJZ are located in the same row, and the first pins YJ1 in different sets of first pins YJZ are located in different rows. For example, each pin unit YJD includes three sets of first pins YJZ, that is, each pin unit YJD includes three rows of first pins YJ1.

N sets of first pins YJZ in the same pin unit YJD are arranged along a third direction. The first direction Y, the second direction X and the third direction intersect with each other. Two adjacent pin units YJD may be the same or different in terms of the arrangement of the sets of first pins YJZ. When the sets of first pins YJZ in two adjacent pin units YJD adopt the same arrangement, the sets of first pins YJZ in one of the pin units YJD may be shifted in the second direction X. For example, the second pin unit YJD2 is shifted to the right as a whole compared to the first pin unit YJD1,so that the output leads 322 electrically connected to these two pin units YJD may be staggered, and routing bends may be reduced.

Referring to FIG. 8A, a first side S1 of the first pin YJ1 may refer to a left side of the first pin YJ1, and a second side S2 of the first pin YJ1 may refer to a right side of the first pin YJ1. In a set of first pins YJZ (or in a row of first pins YJ1), an orthographic projection of the first sides S1 of two adjacent first pins YJ1 on the first substrate 311 defines a first range F1. The first range F1 may refer to a range defined with the first side S1 of one of the two adjacent first pins YJ1 as a left boundary and the first side S1 of the other as a right boundary.

In embodiments of the present disclosure, a value of M may be calculated according to parameters such as an available width of the driver chip 310 and a width of the output lead 322. Optionally, when two pin units YJD are provided in the driver chip, M may be 6, that is, six first pins YJ1 may be arranged in the first range F1. When a size of the driver chip 310 only allows 2000 first pins YJ1 to be arranged in a row, the number of first pins YJ1 may be increased to 12000 through this method.

Optionally, when three pin units YJD are provided in the driver chip, M may be 9, that is, nine first pins YJ1 may be arranged in the first range F1. When the size of the driver chip 310 only allows 1300 first pins YJ1 to be arranged in a row, the number of first pins YJ1 may be increased to over 11000 through this method.

It should be understood that the more pin units YJD, the larger the value of M, and thus more first pins YJ1 may be provided. It should be noted that the value of M may be determined according to actual needs. For example, M may also be set as 4, 8, 12, etc., which will not be exhaustively listed in embodiments of the present disclosure.

Referring to FIG. 7, in some specific embodiments, the first window unit CKD1 includes a plurality of sets of first windows CKZ1 and a plurality of sets of second windows CKZ2. At least one set of first windows CKZ1 includes a plurality of first windows CK1 arranged along a fourth direction, and at least one set of second windows CKZ2 includes a plurality of second windows CK2 arranged along the fourth direction. The plurality of sets of first windows CKZ1 are arranged along the second direction X, and the plurality of sets of second windows CKZ2 are arranged along the second direction X. The first direction Y, the second direction X, the third direction and the fourth direction intersect with each other.

Referring to FIG. 7, the set of first windows CKZ1 may include an inclined column of first windows CK1, and the set of second windows CKZ2 may include an inclined column of second windows CK2. In an example, an inclination degree of the fourth direction is greater than that of the third direction, which helps to align the arrangement of the exposed first pins YJ1 with the arrangement of the output leads 322 on the flexible printed circuit board 320. The inclination degree of the third direction (or the fourth direction) may refer to an inclination degree of the third direction (or the fourth direction) with respect to the first direction Y (vertical direction). For example, the larger the angle between the third direction (or the fourth direction) and the first direction Y, the greater the inclination degree.

Referring to FIG. 7, FIG. 8A and FIG. 11 in combination, in at least one set of first windows CKZ1, at least one first window CK1 exposes the first pin YJ1 in at least one set of first pins YJZ, and different first windows CK1 expose the first pins YJ1 in different set of first pins YJZ. In at least one set of second windows CKZ2, at least one second window CK2 exposes the first pin YJ1 in at least one set of first pins YJZ, and different second windows CK2 expose the first pins YJ1 in different set of first pins YJZ.

Referring to FIG. 8A, in each pin unit YJD, a plurality of first pins YJ1 arranged along the second direction X (that is, a set of first pins YJZ) are referred to as a row of first pins YJ1, and a plurality of first pins YJ1 arranged along the third direction are referred to as a column of first pins YJ1. Each set of first windows CKZ1 includes a plurality of first windows CK1 arranged along the fourth direction. Taking the first pin unit YJD1 as an example, in the set of first windows CKZ1, a first one of the first windows CK1 exposes the first pin YJ1 in a first row and a first column, a second one of the first windows CK1 exposes the first pin YJ1 in a second row and a first column, a third one of the first windows CK1 exposes the first pin YJ1 in a third row and a first column, and so on.

The second pin unit YJD2 and the second windows CK2 may be arranged in the same way, which will not be repeated here.

In embodiments of the present disclosure, if a total of 12000 first pins YJ1 are arranged on the driver chip 310, and 2000 output units SCD are arranged in the driver chip 310, then the multiplexing unit MX may be configured to include six gating modules. In this case, each output unit SCD may be electrically connected to six first pins YJ1 through a multiplexing unit MX, so that 2000 output units SCD may be electrically connected to 12000 first pins YJ1.

In embodiments of the present disclosure, in order to adapt to at least a flexible printed circuit board 320 with two lead layers, the 2000 output units SCD are divided into 1000 first output units SCD1 and 1000 second output units SCD2. Accordingly, a first output unit SCD1 and a second output unit SCD2 are electrically connected to a total of twelve first pins YJ1. Therefore, twelve first pins YJ1 may be taken as a minimum numbering unit, and pin numbers may be assigned to the 12000 first pins YJ1 based on the minimum numbering unit. Referring to FIG. 8A and FIG. 8B in combination, thirty-six first pins YJ1 constitute a minimum numbering repetition unit.

In embodiments of the present disclosure, in the plurality of pin units YJD, the pin numbers of the first pins YJ1 located in the same row and the same column next to each other sequentially. Referring to FIG. 8A, three pin units YJD are arranged on the driver chip 310, and each pin unit YJD includes three rows of first pins YJ1. In embodiments of the present disclosure, the first pins YJ1 in the first row and the first column of the three pin units YJD are sequentially assigned pin numbers "101", "102", "103". Then, the first pins YJ1 in the second row and the first column of the three pin units YJD are sequentially assigned pin numbers "104", "105", "106". Then, the first pins YJ1 in the third row and the first column of the three pin units YJD are sequentially assigned pin numbers "107", "108", "109". Subsequently, the first pins YJ1 in the first row and the second column of the three pin units YJD are sequentially assigned pin numbers "110", "111", "112". So far, pin numbering of a minimum numbering unit (twelve pin numbers) is completed. Then, starting from the first pins YJ1 in the second row and the second column of the three pin units YJD, a next round of pin numbering begins until twelve pin numbers are assigned. This process continues analogously to complete the numbering for a minimum numbering repetition unit

Optionally, in embodiments of the present disclosure, the first output unit SCD1 is electrically connected to the first pins YJ1 with odd pin numbers through the multiplexing unit MX. For example, the first output unit SCD1 is electrically connected to the first pin YJ1 with a pin number ending in "01" through the first gating module M1, to the first pin YJ1 with a pin number ending in "03" through the second gating module M2, to the first pin YJ1 with a pin number ending in "05" through the third gating module M3, to the first pin YJ1 with a pin number ending in "07" through the fourth gating module M4, to the first pin YJ1 with a pin number ending in "09" through the fifth gating module M5, and to the first pin YJ1 with a pin number ending in "11" through the sixth gating module M6.

Optionally, the second output unit SCD2 is electrically connected to the first pins YJ1 with even pin numbers through the multiplexing unit MX. For example, the first output unit SCD1 is electrically connected to the first pin YJ1 with a pin number ending in "02" through the first gating module M1, to the first pin YJ1 with a pin number ending in "04" through the second gating module M2, to the first pin YJ1 with a pin number ending in "06" through the third gating module M3, to the first pin YJ1 with a pin number ending in "08" through the fourth gating module M4, to the first pin YJ1 with a pin number ending in "10" through the fifth gating module M5, and to the first pin YJ1 with a pin number ending in "12" through the sixth gating module M6.

In this case, the first pins YJ1 electrically connected to the output unit SCD are distributed in three pin units YJD, and the first pins YJ1 electrically connected to the output units SCD through the first gating modules M1 are in the first pin unit YJD1 and the second pin unit YJD2. Then, according to the type of the flexible printed circuit board 320, it may be determined which first pins YJ1 on the driver chip 310 are exposed.

For example, when the flexible printed circuit board 320 is provided with the first lead layer 325 and the second lead layer 326 as described in the aforementioned embodiments, the first window unit CKD1 may be set to expose the first pins YJ1 electrically connected to the first gating modules M1 in the first pin unit YJD1 and the second pin unit YJD2. In an example, taking the first pin unit YJD1 as an example, in a set of first windows CKZ1, a first one of the first windows CK1 exposes the first pin YJ1 in the first row and the first column, a second one of the first windows CK1 exposes the first pin YJ1 in the second row and the second column, and a third one of the first windows CK1 exposes the first pin YJ1 in the third row and the third column. Thus, each first window CK1 exposes a first pin YJ1 electrically connected to the first gating module M1, and different first windows CK1 expose first pins YJ1 electrically connected to different output units SCD.

Taking the second pin unit YJD2 as an example, in a set of second windows CKZ2, a first one of the second windows CK2 exposes the first pin YJ1 in the first row and the first column, a second one of the second windows CK2 exposes the first pin YJ1 in the second row and the second column, and a third one of the second windows CK2 exposes the first pin YJ1 in the third row and the third column. Thus, each second window CK2 exposes a first pin YJ1 electrically connected to the first gating module M1, and different second windows CK2 expose first pins YJ1 electrically connected to different output units SCD. Moreover, for any first window CK1 and any second window CK2, the first pins YJ1 exposed by the two are electrically connected to different output units SCD. In addition, the arrangement of the first windows CK1 and the second windows CK2 allows a flexible printed circuit board 320 with two lead layers to be directly pressed onto the driver chip 310 to complete a bonding alignment, thus simplifying a bonding process and reducing transition structures.

When the flexible printed circuit board 320 is provided with the first lead layer 325, the third lead layer 327 and the fourth lead layer 329 as described in the aforementioned embodiments and has 12000 output leads 322, in embodiments of the present disclosure, all the first pins YJ1 may be exposed through the first windows CK1 to the fifth windows CK5, so that 12000 output channels may be formed.

It should be noted that the above is merely an exemplary description, which does not constitute a limitation to embodiments of the present disclosure. For example, in a set of first windows CKZ1 (or set of second windows CKZ2), the plurality of first windows CK1 (or second windows CK2) may be arranged along the second direction X. In this case, the connection method between the first pins YJ1 and the output units SCD needs to be adjusted accordingly, so that these first windows CK1 (or second windows CK2) expose the required first pins YJ1.

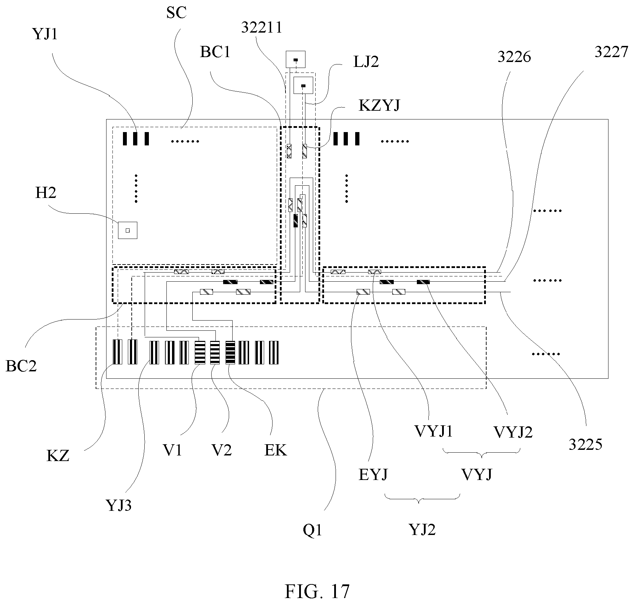

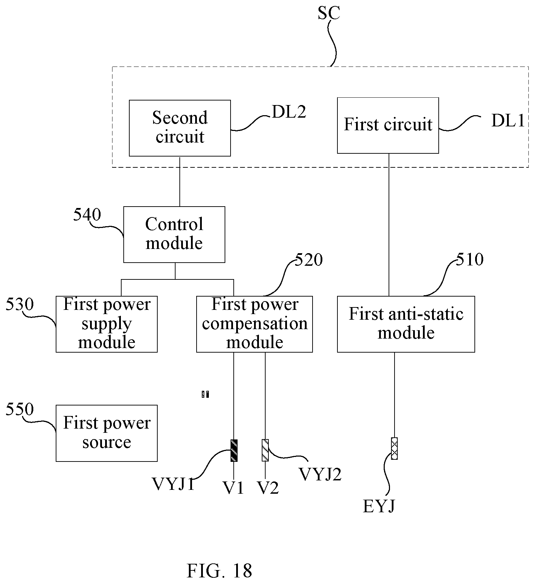

FIG. 17 schematically shows a first schematic diagram of second pins according to an embodiment of the present disclosure, and FIG. 18 schematically shows a schematic diagram of a first anti-static module and a first power compensation module according to an embodiment of the present disclosure.

Referring to FIG. 17 and FIG. 18 in combination, in some specific embodiments, the driver chip 310 further includes: a plurality of second pins YJ2 on the first substrate 311, a first anti-static module 510 and a first power compensation module 520 on the first substrate 311, and an electrostatic discharge interface EK and a power compensation interface VK in the first region Q1.

The first anti-static module 510 is electrically connected to the electrostatic discharge interface EK through at least one of the plurality of second pins YJ2, and the first power compensation module 520 is electrically connected to the power compensation interface VK through at least another one of the plurality of second pins YJ2. The second region Q2 includes a first compensation sub-region BC1 and a second compensation sub-region BC2. The first compensation sub-region BC1 separates two adjacent output sub-regions SC, and the second compensation sub-region BC2 is located on a side of the plurality of output sub-regions SC close to the first region Q1. The plurality of second pins YJ2 are located in at least one of the first compensation sub-region BC1 or the second compensation sub-region BC2.

Referring to FIG. 17, the electrostatic discharge interface EK and the power compensation interface VK are located at the lower end of the driver chip 310. Optionally, the signal input interface JK may include a plurality of third pins YJ3, which may be arranged along the second direction X. The third pins YJ3 may be electrically connected to the input leads 323 on the flexible printed circuit board 320, and then provide input signals to the driver chip 310. The electrostatic discharge interface EK and the power compensation interface VK may be arranged in the same row as the plurality of third pins YJ3. For example, the electrostatic discharge interface EK and the power compensation interface VK may be located between two adj acent third pins YJ3. However, this is not limited in embodiments of the present disclosure. For example, in some embodiments, the electrostatic discharge interface EK and the power compensation interface VK are arranged in the same row, and the plurality of third pins YJ3 are located in another row.

In embodiments of the present disclosure, the electrostatic discharge interface EK and the power compensation interface VK may be electrically connected to the second bonding terminal BD2 through the leads on the flexible printed circuit board 320, and then electrically connected to devices such as the printed circuit board 500 located on the back side of the display panel 400, so as to form an electrostatic discharge path and a power compensation path.

Compared with an existing driver chip 310, the number of first pins YJ1 in embodiments of the present disclosure is significantly increased. Therefore, in embodiments of the present disclosure, the first anti-static module 510, the first power compensation module 520, the second pins YJ2, the electrostatic discharge interface EK and the power compensation interface VK are further provided in the driver chip 310. The first anti-static module 510 is electrically connected to the electrostatic discharge interface EK through the second pins YJ2 on the one hand, and may be further electrically connected to a first circuit DL1 in the output sub-region SC on the other hand, so as to perform an anti-static compensation for the first circuit DL1. Correspondingly, the first power compensation module 520 is electrically connected to the power compensation interface VK through the second pins YJ2 on the one hand, and may be further electrically connected to a second circuit DL2 in the output sub-region SC on the other hand, so as to perform a power compensation for the second circuit DL2. It should be noted that the first circuit DL1 and the second circuit DL2 in the output sub-region SC include, but are not limited to, various circuits connected between the output unit SCD and the first pins YJ1. These circuits may process the signals output by the output unit SCD and transmit the processed signals to the first pins YJ1. For example, these circuits may include the multiplexing unit MX described in the aforementioned embodiments.

Optionally, the first anti-static module 510 may include a power clamp circuit, and the first power compensation module 520 may include a current bias control circuit. Embodiments of the present disclosure are equivalent to providing an anti-static compensation and a power compensation for the relevant circuits in the output sub-region SC, in the form of external compensation circuits.

In some specific embodiments, the plurality of second pins YJ2 include anti-static compensation pins EYJ and power compensation pins VYJ.

The first anti-static module 510 is electrically connected to the anti-static compensation pins EYJ, and the first power compensation module 520 is electrically connected to the power compensation pins VYJ.

In some embodiments, the anti-static compensation pins EYJ and the power compensation pins VYJ are arranged between any two adjacent output sub-regions SC, so that a plurality of anti-static compensation pins EYJ and power compensation pins VYJ are uniformly distributed between the plurality of output sub-regions SC.

In some embodiments, the anti-static compensation pins EYJ and the power compensation pins VYJ are arranged on a side of each output sub-region SC close to the first region Q1, so that a plurality of anti-static compensation pins EYJ and power compensation pins VYJ are uniformly distributed below the plurality of output sub-regions SC.

In this way, the anti-static compensation pins EYJ and the power compensation pins VYJ may be arranged as densely as possible around each output sub-region SC to minimize compensation dead zones.

It should be noted that the arrangement of the anti-static compensation pins EYJ and the power compensation pins VYJ may be determined according to actual needs, which is not limited in embodiments of the present disclosure. For example, between two adjacent output sub-regions SC, the number of anti-static compensation pins EYJ may be the same as or different from the number of power compensation pins VYJ, the arrangement of the anti-static compensation pins EYJ and power compensation pins VYJ between each two output sub-regions SC may be consistent, so as to improve the uniformity of pin arrangement.

In some specific embodiments, the display driver assembly 300 further includes a flexible printed circuit board 320. The flexible printed circuit board 320 includes: a second substrate 324, a first lead layer 325 on the second substrate 324, and a fifth lead 3225, a sixth lead 3226 and a seventh lead 3227 which are disposed on the second substrate 324 and located in the first lead layer 325.

The first lead layer 325 is located on a side of the second substrate 324 facing the driver chip 310. For specific details, reference may be made to the aforementioned embodiments and will not be repeated here. The power compensation interface VK includes a first voltage terminal V1 and a second voltage terminal V2. The power compensation pins VYJ include a first compensation pin VYJ1 and a second compensation pin VYJ2. The anti-static compensation pin EYJ is electrically connected to the electrostatic discharge interface EK through the fifth lead 3225, the first compensation pin VYJ1 is electrically connected to the first voltage terminal V1 through the sixth lead 3226, and the second compensation pin VYJ2 is electrically connected to the second voltage terminal V2 through the seventh lead 3227. In an example, one of the first voltage terminal V1 and the second voltage terminal V2 may be used to provide a high-level voltage signal, and the other may be used to provide a low-level voltage signal.

In embodiments of the present disclosure, the flexible printed circuit board 320 may be the flexible printed circuit board 320 including the first lead layer 325 and the second lead layer 326 as described in the aforementioned embodiments. When the fifth lead 3225 (the sixth lead 3226 and the seventh lead 3227) needs cross-connection, it is required to provide a hole in the second substrate 324 of the flexible printed circuit board 320 so that the fifth lead 3225 (the sixth lead 3226 and the seventh lead 3227) may be connected to the corresponding lead in the second lead layer 326 through the via hole. However, as described above, a hole formed in the second substrate 324 generally has a large hole diameter, which may easily lead to short-circuiting or other issues.

In view of this, in embodiments of the present disclosure, the fifth lead 3225, the sixth lead 3226 and the seventh lead 3227 extend along the second direction X in the second compensation sub-region BC2, and in the first compensation sub-region BC1, the fifth lead 3225, the sixth lead 3226 and the seventh lead 3227 are bent towards the side away from the first compensation sub-region BC1. An orthographic projection of the fifth lead 3225 on the first substrate 311, an orthographic projection of the sixth lead 3226 on the first substrate 311 and an orthographic projection of the seventh lead 3227 on the first substrate 311 do not overlap with each other.

Referring to FIG. 17, in the second compensation sub-region BC2, the fifth lead 3225, the sixth lead 3226 and the seventh lead 3227 extend along the horizontal direction in the figure, and in the first compensation sub-region BC1, the fifth lead 3225, the sixth lead 3226 and the seventh lead 3227 are all bent upward. These three leads extend in substantially the same direction but do not overlap with each other, thus forming a nested structure. In this way, on the one hand, a plurality of anti-static compensation pins EYJ (the first compensation pins VYJ1 or the second compensation pins VYJ2) may be electrically connected to the same fifth lead 3225 (the sixth lead 3226 or the seventh lead 3227), thus reducing the number of wires; on the other hand, the fifth lead 3225, the sixth lead 3226 and the seventh lead 3227 may be arranged without overlapping with each other, thus avoiding cross-connection of wires and eliminating the need to form holes in the second substrate 324.

In some specific embodiments, the driver chip 310 further includes a signal extension interface KZ in the first region Q1 and a signal extension pin KZYJ on the first substrate 311. The flexible printed circuit board 320 further includes a second lead layer 326, a second connecting line LJ2 and an eleventh lead 32211 that are disposed on the second substrate 324. The second connecting line LJ2 is located in the first lead layer 325, and the eleventh lead 32211 is located in the second lead layer 326.

The signal extension pin KZYJ is located in the first compensation sub-region BC1 and on a side of the plurality of second pins YJ2 away from the first region Q1. The signal extension pin KZYJ is electrically connected to the eleventh lead 32211 through the second connecting line LJ2, and the eleventh lead 32211 is electrically connected to the signal extension interface KZ.

In embodiments of the present disclosure, the signal extension pins KZYJ are used to provide additional signals, such as digital signals, to the relevant circuits in the output sub-region SC. Referring to FIG. 17, the signal extension pins KZYJ are located above the second pins YJ2. The number and arrangement of the signal extension pins KZYJ may be determined according to actual needs, which is not limited in embodiments of the present disclosure.

In embodiments of the present disclosure, the second connecting line LJ2 may extend, from the signal extension interface KZ, towards the side away from the first region Q1, and may be electrically connected to the eleventh lead 32211 in the second lead layer 326 through a via hole in the second substrate 324 after reaching a specified position. The eleventh lead 32211 extends towards the first region Q1 and is electrically connected to the signal extension interface KZ in the first region Q1. The signal extension interface KZ may be electrically connected to the second bonding terminal BD2 through the leads on the flexible printed circuit board 320, and further electrically connected to devices such as the printed circuit board 500 on the back side of the display panel 400, thereby forming a signal extension path.

In some specific embodiments, at least one first via hole H1 is formed in the second substrate 324, and a size of the first via hole H1 is greater than or equal to a distance between two first pins YJ1 adjacent in the second direction X. The second connecting line LJ2 and the eleventh lead 32211 are electrically connected to each other through the first via hole H1, and the first via hole H1 is located on a side of the signal extension pin KZYJ away from the first region Q1.

A j^{th} first via hole H1 is located on a side of a (j+1)^{th} first via hole H1 away from the first region Q1. For the second connecting line LJ2 and the eleventh lead 32211 electrically connected through the (j+1)^{th} first via hole H1, an orthographic projection of the eleventh lead 32211 on the second substrate 324 at least partially surrounds an orthographic projection of the j^{th} first via hole H1 on the second substrate 324, where j is a positive integer.

Referring to FIG. 17, the j^{th} first via hole H1 is located above the (j+1)^{th} first via hole H1. For the second connecting line LJ2 and the eleventh lead 32211 electrically connected through the (j+1)^{th} first via hole H1, the eleventh lead 32211 is divided into two branches, which are located on left and right sides of the (j+1)^{th} first via hole H1 respectively. In the second compensation sub-region BC2, one branch extends towards the left, and the other branch extends towards the right, so that the same signal extension pin KZYJ may be connected to the same eleventh lead 32211.

In embodiments of the present disclosure, the second substrate 324 may be provided with a plurality of first via holes H1. In addition to the first via holes H1, the second substrate 324 may be further provided with second via holes H2, which are used for transition between the first connecting lines LJ1 and the second leads 3222. Referring to FIG. 9 and FIG. 17 in combination, an orthographic projection of the first via hole H1 on the second substrate 324 is located outside the orthographic projection of the driver chip 310 on the second substrate 324. Optionally, an orthographic projection of the second via hole H2 on the second substrate 324 is located within the orthographic projection of the output sub-region SC on the second substrate 324. Optionally, the first via hole H1 and the second via hole H2 have substantially the same opening size.

In some specific embodiments, an orthographic projection of the second connecting line LJ2 and the eleventh lead 32211 on the first substrate 311 is located between orthographic projections of two adjacent output sub-regions SC on the first substrate 311. Referring to FIG. 17, neither the second connecting line LJ2 nor the eleventh lead 32211 passes through the output sub-region SC, thereby avoiding interference with the leads in the output sub-region SC.

It should be noted that FIG. 17 only shows two output sub-regions SC and their surrounding structures on the driver chip 310. It may be understood that in embodiments of the present disclosure, any two output sub-regions SC and their surrounding structures may be the same, which will not be repeated in embodiments of the present disclosure.

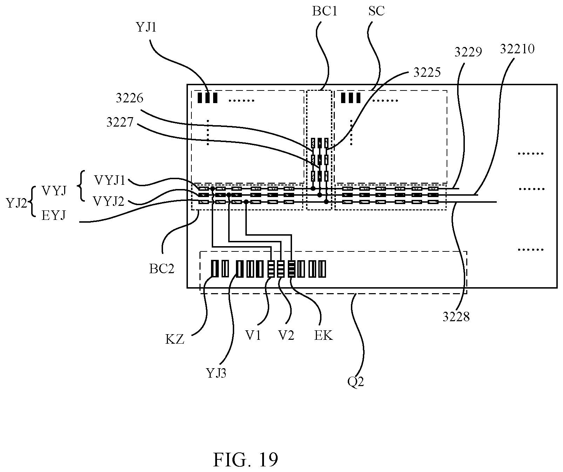

FIG. 19 schematically shows a second schematic diagram of second pins according to an embodiment of the present disclosure.

Referring to FIG. 18 and FIG. 19 in combination, in some specific embodiments, the display driver assembly 300 further includes a flexible printed circuit board 320. The flexible printed circuit board 320 includes: a second substrate 324; a fifth lead 3225, a sixth lead 3226, a seventh lead 3227, an eighth lead 3228, a ninth lead 3229 and a tenth lead 32210 that are disposed on the second substrate 324 and located in the first lead layer 325; and a transition portion located in the third lead layer 327.

In embodiments of the present disclosure, the flexible printed circuit board 320 may be the flexible printed circuit board 320 including the first lead layer 325 and the third lead layer 327 as described in the aforementioned embodiments. Since the first lead layer 325 and the third lead layer 327 are located on the same side of the second substrate 324, if the fifth lead 3225 (the sixth lead 3226 and the seventh lead 3227) requires cross-connection, it is possible to form a hole in the insulating layer between the first lead layer 325 and the third lead layer 327. This hole has a small diameter, so that short circuiting and other issues may be avoided.

Specifically, the first lead layer 325 is located on the side of the second substrate 324 facing the driver chip 310, and the third lead layer 327 is located between the first lead layer 325 and the second substrate 324. For specific details, reference may be made to the aforementioned embodiments, which will not be repeated here. The fourth lead 3224, the fifth lead 3225 and the sixth lead 3226 are located in the first compensation sub-region BC1 and extend along the first direction Y. The eighth lead 3228, the ninth lead 3229 and the tenth lead 32210 are located in the second compensation sub-region BC2 and extend along the second direction X. The power compensation interface VK includes a first voltage terminal V1 and a second voltage terminal V2. The power compensation pins VYJ include a first compensation pin VYJ1 and a second compensation pin VYJ2. The anti-static compensation pin EYJ is electrically connected to the fifth lead 3225, the first compensation pin VYJ1 is electrically connected to the sixth lead 3226, and the second compensation pin VYJ2 is electrically connected to the seventh lead 3227. The fifth lead 3225 is electrically connected to the electrostatic discharge interface EK through the eighth lead 3228, the sixth lead 3226 is electrically connected to the first voltage terminal V1 through the ninth lead 3229, and the seventh lead 3227 is electrically connected to the second voltage terminal V2 through the tenth lead 32210. At least two of the fifth lead 3225, the sixth lead 3226, the seventh lead 3227, the eighth lead 3228, the ninth lead 3229 and the tenth lead 32210 have overlapping orthographic projections on the first substrate 311, and in an overlapping region, one of the at least two leads is connected to the transition portion.

Referring to FIG. 19, in the second compensation sub-region BC2, the eighth lead 3228, the ninth lead 3229 and the tenth lead 32210 extend along the horizontal direction shown in the figure, and in the first compensation sub-region BC1, the fifth lead 3225, the sixth lead 3226 and the seventh lead 3227 extend along the first direction Y. The ninth lead 3229 overlaps with the fifth lead 3225, thus requiring a cross-connection. The tenth lead 32210 overlaps with both the fifth lead 3225 and the sixth lead 3226, thus requiring two cross-connections. Through the above-mentioned method, the wire length may be reduced, thereby reducing electrical losses on these leads.

Referring to FIG. 18, in some specific embodiments, the driver chip 310 further includes a first power supply module 530 and a control module 540. The first power supply module 530 is electrically connected to a first power source 550. The first power supply module 530 and the first power compensation module 520 are electrically connected to at least one output sub-region SC through the control module 540. The control module 540 is used to: in a frame period, in response to a control instruction, connect or disconnect the output sub-region SC electrically connected to the control module 540 to or from the first power supply module 530, and/or connect or disconnect the output sub-region SC electrically connected to the control module 540 to or from the first power compensation module 520.

In embodiments of the present disclosure, the first power supply module 530 may be an original basic power supply module of the driver chip 310, and the power compensation module is a newly added power supply module in embodiments of the present disclosure. The control module 540 may control whether to supply power to the output sub-region SC to achieve partial refresh in a frame period. For example, in a frame period, the control module 540 may disconnect the output sub-region SC electrically connected to the control module 540 from both the first power supply module 530 and the first power compensation module 520. In this case, power supply to the output sub-region SC is stopped in this frame period. As a result, in this frame period, the data lines electrically connected to the first pins YJ1 in the output sub-region SC maintain the data voltage signals from a previous frame. Consequently, several columns of sub-pixels electrically connected to these data lines retain a display image from the previous frame. When the control module 540 connects the output sub-region SC electrically connected to the control module 540 to both the first power supply module 530 and the first power compensation module 520, power supply to the output sub-region SC continues in this frame period. As a result, in this frame period, the data lines electrically connected to the first pins YJ1 in the output sub-region SC are refreshed to new data voltage signals. Consequently, several columns of sub-pixels electrically connected to these data lines are refreshed to a new display image.

That is to say, in embodiments of the present disclosure, in each frame period, it is possible to separately control a power supply state of each output sub-region SC, and further control whether several columns of sub-pixels retain the image from the previous frame. Thus, the display region AA may be divided into a plurality of first display sub-regions with several columns of sub-pixels as a unit, that is, the display region AA is divided into a plurality of first display sub-regions in the row direction, and then a refresh state of each first display sub-region may be controlled to achieve partial refresh.

In some specific embodiments, it is also possible to control whether several rows of sub-pixels PX retain an image from a previous frame by using the gate lines GL. For example, in a frame period, a valid signal is provided to gate lines GL for several rows of sub-pixels PX, so that the current data voltage signals on the data lines DL may be written into these sub-pixels PX. In this case, these rows of sub-pixels PX may achieve image refresh. In this frame period, an invalid signal is provided to the gate lines GL for several other rows of sub-pixels PX. In this case, the current data voltage signals on these data lines DL may not be written into these sub-pixels PX, and these rows of sub-pixels PX may retain the image from the previous frame. Thus, in embodiments of the present disclosure, the display region AA may be divided into a plurality of second display sub-regions with several rows of sub-pixels PX as a unit, that is, the display region AA is divided into a plurality of second display sub-regions in the column direction.

In this way, the plurality of first display sub-regions and the plurality of second display sub-regions intersect with each other, and overlapping regions thereof may define a plurality of display blocks. Therefore, in embodiments of the present disclosure, partial refresh may be achieved in terms of display blocks, the control is more refined, and power consumption may be reduced.

Referring to FIG. 17 and FIG. 19 in combination, in some specific embodiments, at least two first pins YJ1 are arranged along the second direction X, and at least two second pins YJ2 are arranged along the second direction X.

In the second direction X, two adjacent first pins YJ1 are separated by a first distance, and two adjacent second pins YJ2 are separated by a second distance. The second distance is greater than or equal to the first distance.

In embodiments of the present disclosure, the first distance may refer to an average distance or a maximum distance between two adjacent first pins YJ1; the second distance may refer to an average distance or a maximum distance between two adjacent second pins YJ2. The second distance is used to adjust the number of second pins YJ2 allowed to be placed between two adjacent output sub-regions SC.

In embodiments of the present disclosure, the second distance is equal to the first distance, thereby allowing as many second pins YJ2 as possible to be placed between two adjacent output sub-regions SC.

In summary, compared with conventional display driver assemblies, the display driver assembly in embodiments of the present disclosure has high compatibility (support both high-output-channel and low-output-channel requirements) and may separately control the power supply to each output sub-region SC, thereby achieving more refined partial refresh to reduce power consumption, which greatly improves the competitiveness of products.

At least some embodiments of the present disclosure further provide a display module. The display panel 400 includes the display panel 400 described in the aforementioned embodiments, which has a display region AA, a peripheral region NA, and related structures therein. In an example, the display panel 400 may be a liquid crystal display panel (LCD) or an organic light emitting diode display panel (OLED).

At least some embodiments of the present disclosure further provide a display device. The display device may include any device or product with a display function. For example, the display device may be a smart phone, a mobile phone, an e-book reader, a desktop computer (PC), a laptop PC, a netbook PC, a personal digital assistant (PDA), a portable multimedia player (PMP), a digital audio player, a mobile medical device, a camera, a wearable device (such as a head-mounted device, electronic clothing, an electronic bracelet, an electronic necklace, an electronic accessory, an electronic tattoo, or a smart watch), a television, etc.

It should be understood that the above-mentioned display module and display device have all the features and advantages of the above-mentioned display driver assembly, and specific details may refer to the above description, which will not be repeated here.

Those skilled in the art may understand that the features described in embodiments of the present disclosure may be combined and/or integrated in various ways, even if such combinations or integrations are not explicitly described in the present disclosure. In particular, without departing from the spirit and teachings of the present disclosure, the features described in embodiments of the present disclosure may be combined and/or integrated in various ways. All such combinations and integrations fall within the scope of the present disclosure.

Embodiments of the present disclosure have been described above. However, these embodiments are merely for the purpose of illustration and are not intended to limit the scope of the present disclosure. Although the embodiments have been described separately above, this does not mean that the measures in the embodiments cannot be advantageously combined for use. The scope of the present disclosure is defined by the appended claims and their equivalents. Without departing from the scope of the present disclosure, those skilled in the art may make various substitutions and modifications, and these substitutions and modifications should all fall within the scope of the present disclosure.

## Claims

1. A display driver assembly, comprising a driver chip, wherein the driver chip comprises a first region and a second region arranged along a first direction, the first region comprises at least one signal input interface, and the second region comprises:
a first substrate;
a first conductive layer on the first substrate;
a first insulating layer on a side of the first conductive layer away from the first substrate;
a plurality of output sub-regions on the first substrate, wherein the plurality of output sub-regions are arranged along a second direction, at least one output sub-region comprises a plurality of pin units arranged along the first direction, and at least one pin unit comprises a plurality of first pins;
a plurality of output units on the first substrate, wherein at least one output unit is electrically connected to the plurality of first pins through a multiplexing unit, and different output units are electrically connected to different first pins; and
a first window unit in the first insulating layer, wherein the first window unit comprises a plurality of windows, the plurality of windows in the first window unit comprise a plurality of first windows and a plurality of second windows, and the plurality of second windows are located on a side of the plurality of first windows close to the first region;
wherein the plurality of pin units comprise a first pin unit and a second pin unit, the second pin unit is located on a side of the first pin unit close to the first region, the plurality of first windows expose at least one of the first pins in the first pin unit, the plurality of second windows expose at least one of the first pins in the second pin unit, and first pins exposed by any two of the plurality of first windows and the plurality of second windows are electrically connected to different output units.

2. The display driver assembly according to claim 1, wherein the display driver assembly further comprises a flexible printed circuit board, and the flexible printed circuit board comprises:
a second substrate;
a first lead layer and a second lead layer on the second substrate, wherein the first lead layer is located on a side of the second substrate facing the driver chip, and the second lead layer is located on a side of the second substrate away from the driver chip; and
a plurality of first leads, a plurality of second leads and a plurality of first connecting lines on the second substrate, wherein the plurality of first leads and the plurality of first connecting lines are located in the first lead layer, the plurality of second leads are located in the second lead layer, and an orthographic projection of the plurality of first connecting lines on the second substrate is located on a side of an orthographic projection of the plurality of first leads on the second substrate close to an orthographic projection of the first region on the second substrate;
wherein the first pins exposed by the first windows are electrically connected to the plurality of first leads, and the first pins exposed by the second windows are electrically connected to the plurality of second leads through the plurality of first connecting lines.

3. The display driver assembly according to claim 1, wherein the display driver assembly further comprises a flexible printed circuit board, and the flexible printed circuit board comprises:
a second substrate;
a first lead layer and a third lead layer on the second substrate, wherein the first lead layer is located on a side of the second substrate facing the driver chip, and the third lead layer is located between the first lead layer and the second substrate; and
a plurality of first leads and a plurality of third leads on the second substrate, wherein the plurality of first leads are located in the first lead layer, the plurality of third leads are located in the third lead layer, and an orthographic projection of the plurality of first leads on the second substrate does not overlap with an orthographic projection of the plurality of second leads on the second substrate;
wherein the first pins exposed by the first windows are electrically connected to the plurality of first leads, and the first pins exposed by the second windows are electrically connected to the plurality of third leads.

4. The display driver assembly according to claim 3, wherein the flexible printed circuit board further comprises:
at least one fourth lead layer on the second substrate, wherein the at least one fourth lead layer is located between the third lead layer and the second substrate; and
at least one set of fourth leads on the second substrate, wherein each set of fourth leads comprises a plurality of fourth leads, the fourth leads in a same set of fourth leads are located in a same fourth lead layer, and the fourth leads in different sets of fourth leads are located in different fourth lead layers;
wherein the plurality of pin units further comprise at least one third pin unit on a side of the second pin unit away from the first pin unit;
wherein the driver chip further comprises at least one second window unit in the first insulating layer, the at least one second window unit comprises a plurality of third windows and is located on a side of the first window unit close to the first region;
wherein the third windows in the at least one second window unit expose the first pins in a same third pin unit, and the third windows in different second window units expose the first pins in different third pin units; and
wherein the first pins exposed by the third windows in the at least one third pin unit are electrically connected to the fourth leads in the at least one set of fourth leads, and the first pins in different third pin units are electrically connected to the fourth leads in different sets of fourth leads.

5. The display driver assembly according to claim 4, wherein an orthographic projection of the fourth leads in a (2n-1)^{th} fourth lead layer on the second substrate defines a first pattern, and an orthographic projection of the fourth leads in a 2n^{th} fourth lead layer on the second substrate defines a second pattern;
an orthographic projection of the first pattern on the second substrate overlaps partially with the orthographic projection of the plurality of first leads on the second substrate, and an orthographic projection of the second pattern on the second substrate overlaps partially with the orthographic projection of the plurality of third leads on the second substrate; and
wherein n is a positive integer.

6. The display driver assembly according to claim 1, wherein the first window unit further comprises a third window unit in the first insulating layer, and the third window unit comprises a plurality of fourth windows and a plurality of fifth windows; and
wherein the plurality of fourth windows expose the first pins not exposed by the first windows in the first pin unit, and the plurality of fifth windows expose the first pins not exposed by the second windows in the second pin unit.

7. The display driver assembly according to claim 1, wherein at least one multiplexing unit comprises a plurality of gating modules, at least one gating module is electrically connected to at least one first pin, and different gating modules are electrically connected to different first pins; and
wherein first pins exposed by any two of the plurality of first windows and the plurality of second windows are electrically connected to gating modules having same port numbers.

8. The display driver assembly according to claim 7, wherein the output units comprise a first output unit and a second output unit, and the plurality of gating modules of the at least one multiplexing unit comprise a first gating module; and
wherein the first output unit is electrically connected to the first pin in the first pin unit through the first gating module of the multiplexing unit, and the second output unit is electrically connected to the first pin in the second pin unit through the first gating module of the multiplexing unit.

9. The display driver assembly according to claim 1, wherein the at least one pin unit comprises N sets of first pins, and in a same pin unit, at least one set of first pins comprises a plurality of first pins arranged along the second direction, the N sets of first pins are arranged obliquely along a third direction, and the first direction, the second direction and the third direction intersect with each other;
wherein at least one first pin comprises a first side and a second side opposite to each other along the second direction, and in the at least one set of first pins YJZ, the first sides of two adjacent first pins define a first range on the first substrate, and an orthographic projection of at least M first pins on the first substrate overlaps with the first range; and
wherein N and M are positive integers, and M≥3.

10. The display driver assembly according to claim 9, wherein the first window unit comprises a plurality of sets of first windows and a plurality of sets of second windows, at least one set of first windows comprises a plurality of first windows arranged along a fourth direction, and at least one set of second windows comprises a plurality of second windows arranged along the fourth direction;
wherein the plurality of sets of first windows are arranged along the second direction, the plurality of sets of second windows are arranged along the second direction, and the first direction, the second direction, the third direction and the fourth direction intersect with each other;
wherein in the at least one set of first windows, at least one first window exposes the first pin in the at least one set of first pins, and different first windows expose the first pins in different sets of first pins; and
wherein in the at least one set of second windows, at least one second window exposes the first pin in the at least one set of first pins, and different second windows expose the first pins in different sets of first pins.

11. The display driver assembly according to claim 1, wherein the driver chip further comprises:
a plurality of second pins on the first substrate;
a first anti-static module and a first power compensation module on the first substrate; and
an electrostatic discharge interface and a power compensation interface in the first region;
wherein the first anti-static module is electrically connected to the electrostatic discharge interface through at least one of the plurality of second pins, and the first power compensation module is electrically connected to the power compensation interface through at least another one of the plurality of second pins; and
wherein the second region comprises a first compensation sub-region and a second compensation sub-region, the first compensation sub-region separates two adjacent output sub-regions, the second compensation sub-region is located on a side of the plurality of output sub-regions close to the first region, and the plurality of second pins are located in at least one of the first compensation sub-region or the second compensation sub-region.

12. The display driver assembly according to claim 11, wherein the plurality of second pins comprise an anti-static compensation pin and a power compensation pin;
wherein the first anti-static module is electrically connected to the anti-static compensation pin, and the first power compensation module is electrically connected to the power compensation pin;
wherein the anti-static compensation pin and the power compensation pin are provided between any two adjacent output sub-regions; and/or
wherein the anti-static compensation pin and the power compensation pin are provided on a side of each output sub-region close to the first region.

13. The display driver assembly according to claim 12, wherein the display driver assembly further comprises a flexible printed circuit board, and the flexible printed circuit board comprises:
a second substrate;
a first lead layer on the second substrate, wherein the first lead layer is located on a side of the second substrate facing the driver chip; and
a fifth lead, a sixth lead and a seventh lead disposed on the second substrate and located in the first lead layer;
wherein the power compensation interface comprises a first voltage terminal and a second voltage terminal, the power compensation pins comprise a first compensation pin and a second compensation pin, the anti-static compensation pin is electrically connected to the electrostatic discharge interface through the fifth lead, the first compensation pin is electrically connected to the first voltage terminal through the sixth lead, and the second compensation pin is electrically connected to the second voltage terminal through the seventh lead;
wherein in the second compensation sub-region, the fourth lead, the fifth lead and the sixth lead extend along the second direction, and in the first compensation sub-region, the fourth lead, the fifth lead and the sixth lead are bent towards a side away from the first compensation sub-region; and
wherein an orthographic projection of the fourth lead on the first substrate, an orthographic projection of the fifth lead on the first substrate, and an orthographic projection of the sixth lead on the first substrate do not overlap with each other.

14. The display driver assembly according to claim 12, wherein the display driver assembly further comprises a flexible printed circuit board, and the flexible printed circuit board comprises:
a second substrate;
a first lead layer on the second substrate, wherein the first lead layer is located on a side of the second substrate facing the driver chip, and a third lead layer is located between the first lead layer and the second substrate;
a fifth lead, a sixth lead, a seventh lead, an eighth lead, a ninth lead and a tenth lead disposed on the second substrate and located in the first lead layer, wherein the fourth lead, the fifth lead and the sixth lead are located in the first compensation sub-region and extend along the first direction, and the eighth lead, the ninth lead and the tenth lead are located in the second compensation sub-region and extend along the second direction; and
a transition portion in the third lead layer,
wherein the power compensation interface comprises a first voltage terminal and a second voltage terminal, the power compensation pins comprise a first compensation pin and a second compensation pin, the anti-static compensation pin is electrically connected to the fifth lead, the first compensation pin is electrically connected to the sixth lead, and the second compensation pin is electrically connected to the seventh lead;
wherein the fifth lead is electrically connected to the electrostatic discharge interface through the eighth lead, the sixth lead is electrically connected to the first voltage terminal through the ninth lead, and the seventh lead is electrically connected to the second voltage terminal through the tenth lead; and
wherein orthographic projections of at least two of the fifth lead, the sixth lead, the seventh lead, the eighth lead, the ninth lead and the tenth lead on the first substrate overlap, and in an overlapping region, one of the at least two is transitioned through the transition portion.

15. The display driver assembly according to claim 13, wherein the driver chip further comprises:
a signal extension interface in the first region; and
a signal extension pin on the first substrate, wherein the signal extension pin is located in the first compensation sub-region and on a side of the plurality of second pins away from the first region;
wherein the flexible printed circuit board 320 further comprises:
a second connecting line and an eleventh lead on the second substrate, wherein the second connecting line is located in the first lead layer, and the eleventh lead is located in the second lead layer; and
wherein the signal extension pin is electrically connected to the eleventh lead through the second connecting line, and the eleventh lead is electrically connected to the signal extension interface.

16. The display driver assembly according to claim 15, wherein at least one first via hole is provided in the second substrate, a size of the first via hole is greater than or equal to a distance between two first pins adjacent in the second direction, the second connecting line and the eleventh lead are electrically connected to each other through the first via hole, and the first via hole is located on a side of the signal extension pin away from the first region; and
wherein a j^{th} first via hole is located on a side of a (j+1)^{th} first via hole away from the first region, and for the second connecting line and the eleventh lead electrically connected to each other through the (j+1)^{th} first via hole, the second connecting line surrounds at least partially the j^{th} first via hole, where j is a positive integer.

17. The display driver assembly according to claim 15, wherein a projection of the second connecting line and the eleventh lead on the first substrate is located between orthographic projections of two adjacent output sub-regions on the first substrate.

18. The display driver assembly according to claim 11, wherein the driver chip further comprises a first power supply module and a control module; and
wherein the first power supply module is electrically connected to a first power source, the first power supply module and the first power compensation module are electrically connected to at least one output sub-region through the control module, and the control module is configured to: in response to a gating instruction, connect the output sub-region electrically connected to the control module to the first power supply module or disconnect the output sub-region electrically connected to the control module from the first power supply module; and/or connect the output sub-region electrically connected to the control module to the first power compensation module or disconnect the output sub-region electrically connected to the control module from the first power compensation module.

19. The display driver assembly according to claim 11, wherein at least two first pins are arranged along the second direction, and at least two second pins are arranged along the second direction; and
wherein in the second direction, two adjacent first pins have a first distance, and two adjacent second pins have a second distance, and the second distance is greater than or equal to the first distance.

20. A display module, comprising the display driver assembly according to any one of claims 1 to 19.

21. A display device, comprising the display module according to claim 20.
